# FASCICULE DE BREVET EUROPEEN

(11) **EP 2 939 262 B1**
(45) Date de publication et mention de la délivrance du brevet: **09.01.2019**
(21) Numéro de dépôt: 13815511.4
(22) Date de dépôt: 20.12.2013
(51) Int. Cl.: H01L 21/306, H01L 21/311, H01L 21/3213

(54) **PROCÉDÉ MICROÉLECTRONIQUE DE GRAVURE D'UNE COUCHE**
MIKROELEKTRONISCHES VERFAHREN ZUM ÄTZEN EINER SCHICHT
MICROELECTRONIC METHOD FOR ETCHING A LAYER

(30) Priorité: 28.12.2012 FR 1262958
(43) Date de publication de la demande: 04.11.2015
(73) Titulaire: Commissariat à l'Énergie Atomique et aux Énergies Alternatives, 75015 Paris (FR); Centre National de la Recherche Scientifique (C.N.R.S.), 75016 Paris (FR); Université Joseph Fourier, 38041 Grenoble Cédex 9 (FR)
(72) Inventeur: POSSEME, Nicolas, F-38000 Grenoble (FR); JOUBERT, Olivier, F-38240 Meylan (FR); VALLIER, Laurent, F-38240 Meylan (FR)
(74) Mandataire: Hautier, Nicolas
(86) Numéro de dépôt international: PCT/EP2013/077853
(87) Numéro de publication internationale: WO 2014/102222

(56) Documents cités:
- WO-A2-2012/166850
- DE-A1- 10 321 494
- US-A1- 2004 118 805
- US-A1- 2007 243 700
- US-A1- 2009 140 350
- US-A1- 2010 190 324
- US-A1- 2011 139 748
- YANG XIA ET AL: "X-ray photoelectron spectroscopic studies of black silicon for solar cell", JOURNAL OF ELECTRON SPECTROSCOPY AND RELATED PHENOMENA, ELSEVIER SCIENCE PUBLISHERS, AMSTERDAM, NL, vol. 184, no. 11, 26 octobre 2011 (2011-10-26), pages 589-592, XP028442582, ISSN: 0368-2048, DOI: 10.1016/J.ELSPEC.2011.10.004 [extrait le 2011-11-07]

## Description

### DOMAINE TECHNIQUE DE L'INVENTION

La présente invention concerne en général les techniques de gravure utilisées en microélectronique et décrit une nouvelle méthode de gravure.

### ÉTAT DE LA TECHNIQUE

La réduction constante des dimensions des motifs qu'il faut pouvoir graver pour réaliser des circuits intégrés toujours plus denses n'a pu être soutenue qu'en améliorant constamment les techniques de photolithographie et de gravure des couches de matériaux employés pour réaliser les circuits intégrés électroniques ainsi que toutes sortes d'autres dispositifs de tailles micrométriques voire nanométriques combinant dispositifs optiques et mécaniques.

Historiquement, les premières méthodes de gravure utilisées étaient celles que l'on qualifie de « gravure humide ». Elles consistent à mettre en contact une surface du matériau à graver avec une solution appropriée, capable de réagir chimiquement avec celui-ci, et de le dissoudre. Les produits résultant de la gravure doivent être solubles dans la solution de gravure afin qu'ils puissent être enlevées avec elle. La méthode classique consiste à immerger le substrat contenant le dispositif en cours de fabrication dans la solution de gravure.

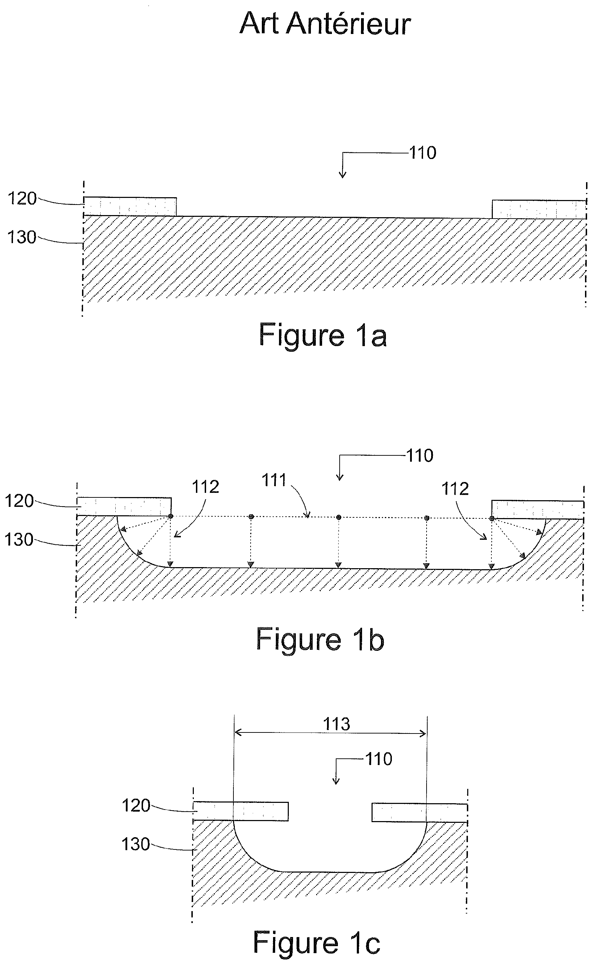

Comme illustré sur la figure 1a les motifs à graver 110 sont d'abord définis dans un masque 120 servant de protection pour les zones inter motifs qui ne doivent pas être gravées dans la couche sous-jacente 130. Typiquement, à l'heure actuelle, le masque 120 est un masque dit dur, traduction de l'anglais « hard mask ». Il est fait d'un matériau approprié pour résister le mieux possible à la solution chimique de gravure. Le masque dur est lui-même obtenu par les procédés classiques de photolithographie et de développement d'une résine photosensible (insolation et dissolution de la résine) de façon à y transférer d'abord les motifs à graver. On notera ici que pendant longtemps, tant que la taille des motifs et les matériaux à graver le permettaient, le masque 120 était fait de résine photosensible qui servait directement à la gravure de la couche sous-jacente 130, souvent de l'oxyde de silicium (SiO2) dans ce cas.

Quelle que soit la nature du masque 120, et celle de la couche 130 sous-jacente, les gravures humides sont caractérisées par le fait qu'elles se font également dans toutes les directions 112 à partir de la surface 111 en contact avec la solution de gravure. La gravure est dite isotrope. Comme illustré sur la figure 1b les zones gravées s'étendent donc, sensiblement en arc de cercle, sous le masque 120.

Tant que les motifs à graver ont été grands vis-à-vis de la profondeur des couches à graver cela n'affectait pas significativement la définition des dimensions critiques ou CD, de l'anglais « critical dimensions », des dispositifs à fabriquer. Avec la réduction des dimensions des motifs 110 jusqu'aux dimensions décananométriques il devient impossible avec ce type de gravure de respecter ces dimensions critiques. Le facteur de forme des motifs à graver a en effet énormément changé au fil d'années de développement. L'augmentation constante de la densité des circuits est obtenue essentiellement avec une réduction de géométrie des motifs alors que les épaisseurs des différentes couches dans lesquelles ils sont formés n'ont pas diminuées, et de loin, dans une même proportion. Ceci est illustré visuellement sur la figure 1c qui montre que la largeur finale 113 des motifs 110 est proportionnellement beaucoup plus affectée par la gravure latérale quand ils sont de petite taille.

Pour pallier cette difficulté on a depuis de nombreuses années désormais recours à des gravures dites « sèches » par bombardement ionique de la cible à graver à l'aide d'un plasma formé dans une chambre de gravure. Le bombardement des ions étant essentiellement perpendiculaire aux surfaces à graver il y a alors, dans des conditions optimales de mise en oeuvre, peu ou pas d'attaque latérale des matériaux à graver et on peut atteindre plus facilement les dimensions critiques. L'avantage principal de ce type de gravure est qu'il peut donc être fortement anisotrope.

On notera ici que l'utilisation d'une gravure plasma anisotrope implique le plus souvent cependant en pratique l'utilisation d'un masque dur car la sélectivité d'attaque de ce type de gravure en fonction des matériaux sur lesquels elle agit est malheureusement beaucoup plus faible que celle que l'on peut obtenir avec les gravures humides. Contrairement aux gravures humides, où il n'y a que peu ou pas de consommation du masque, les gravures sèches ont une sélectivité d'attaque entre les matériaux exposés au bombardement ionique beaucoup moins bonne. En particulier, les résines photosensibles sont alors difficilement utilisables comme masque car il faudrait en effet les déposer en couches très épaisses pour qu'elles ne soient pas entièrement consommées à l'issue de la gravure ce qui est alors incompatible avec la définition de dimensions critiques (CD) dans ces résines.

La solution consiste à réaliser un masque dur dans un matériau suffisamment résistant à la gravure plasma et dans lequel les motifs à graver sont d'abord transférés.

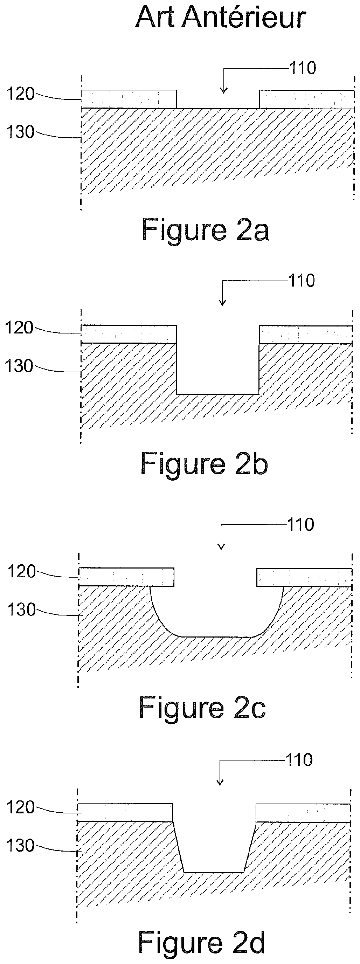

Les figures 2a à 2d illustrent les différents profils de gravure que l'on peut obtenir dans un plasma. Comme montré sur la figure 2b, protégé par un masque dur 120, la gravure peut être idéalement parfaitement anisotrope. Les flancs 131 du motif transféré dans la couche 130 sont alors perpendiculaires à la surface gravée 111.

Toutefois, comme illustré et discuté dans la figure suivante, la gravure plasma fait intervenir de très nombreux paramètres avec des interactions complexes entre eux. En fonction des compromis adoptés on pourra donc aussi observer des profils de gravure partiellement isotropes avec des flancs courbés comme illustré sur la figure 2c ou inclinés comme sur la figure 2d.

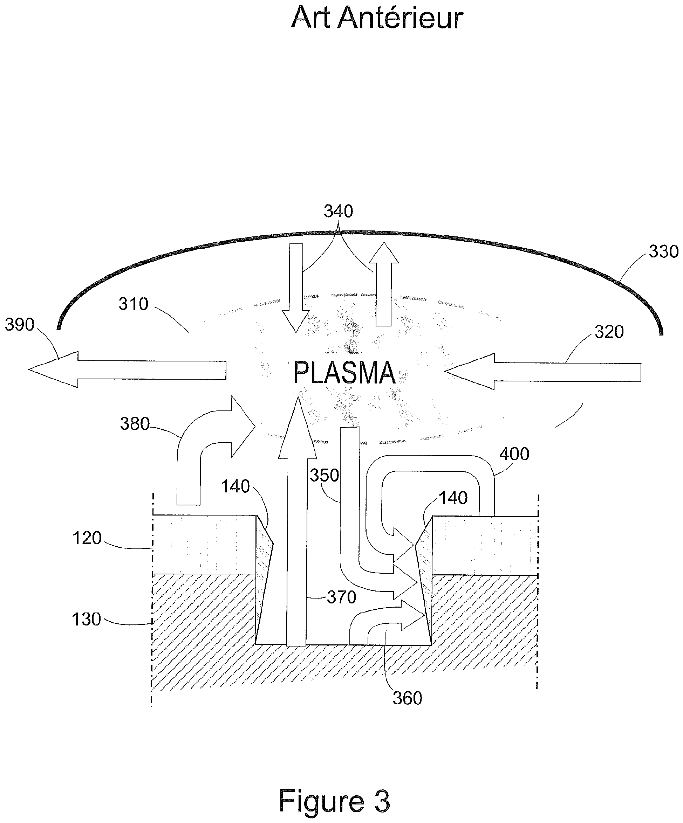

La figure 3 illustre les interactions entre les éléments intervenant lors d'une gravure plasma. De nombreux facteurs sont à prendre en compte pour l'obtention d'une gravure anisotrope :
- Le plasma 310 formé dépend avant tout des espèces gazeuses 320 introduites dans la chambre de gravure et détermine le type de chimie de gravure utilisée. Une chimie couramment utilisée est de type dite fluorocarbonée utilisant par exemple du trifluorométhane (CHF3).
- Les parois 330 du réacteur jouent un rôle important. La condensation des espèces gazeuses sur les parois crée des interactions avec le plasma. Il y a à la fois déposition et pulvérisation 340 des espèces qui y sont déposées.
- L'obtention d'une gravure anisotrope passe par la formation d'une couche de passivation 140 qui protège les flancs tout au long d'une opération de gravure. La couche de passivation est obtenue, depuis le plasma, par le dépôt de produits lourds non volatils 350 et par le dépôt direct 360 de produits provenant du matériau de la couche 130 en train d'être gravée.
- Les produits 370 qui proviennent de la pulvérisation de la couche gravée retournent pour l'essentiel participer au plasma gazeux 310. De la même façon les produits 380 provenant de la consommation du masque dur 120 retournent aussi dans le plasma gazeux. Tous deux sont normalement évacués 390 par pompage de la chambre de gravure avec les gaz introduits 320 pour former le plasma.

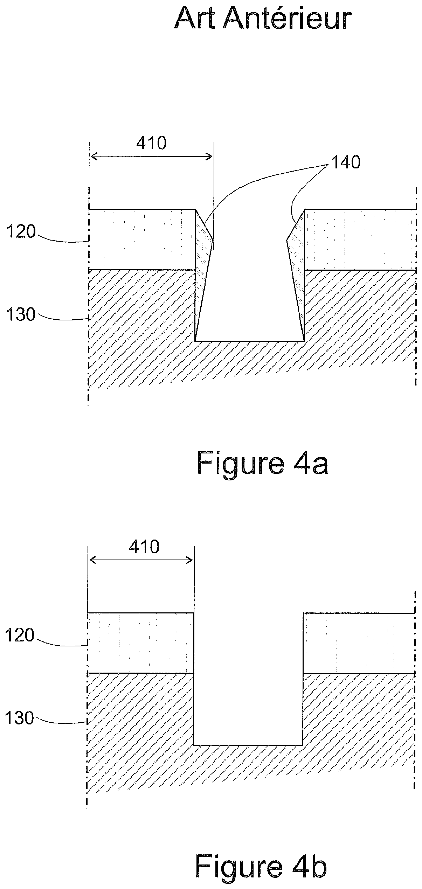

Les figures 4a et 4b illustrent le type de profil anisotrope que l'on peut obtenir avec une gravure plasma.

On notera toutefois que la formation de la couche de passivation 140 peut affecter les dimensions critiques (CD) 410. Comme montré sur la figure 4b, après enlèvement de celle-ci à l'aide d'un nettoyage humide (opération analogue aux gravures humides décrites précédemment), les CD sont réduites. À titre d'exemple, l'objectif pour les grilles des transistors de type MOSFET, acronyme de l'anglais « metal oxyde semiconductor field effect transistor », c'est-à-dire « transistor à effet de champ de type métal-oxyde-semiconducteur » qui constituent l'essentiel des éléments actifs d'un circuit intégré, est actuellement de l'ordre de 10 nanomètres alors que la couche de passivation est d'environ 1 nanomètre.

La gravure plasma présente d'autres inconvénients. Notamment, il y a dépôt de résidus sur la tranche contenant les dispositifs gravés sous la forme de polymères et de métaux lourds provenant, comme montré sur la figure 3 du plasma 350, du matériau en cours de gravure 360 et aussi de la pulvérisation du masque dur 400.

Par ailleurs, de nombreux défauts peuvent être engendrés par la chambre de gravure elle-même et conduire à des baisses de rendement significatives. Comme on l'a vu les parois de la chambre sont affectées par les opérations de gravure. Par exemple, faites d'oxyde d'yttrium, il peut y avoir formation de fluorine d'yttrium avec les gaz introduits pour la formation du plasma (chimie fluorocarbonée). Pour obtenir des résultats reproductibles entre des opérations de gravure successives et entre chambres de gravure celles-ci doivent être systématiquement nettoyées après gravure. Avec la réduction des dimensions des motifs à réaliser, il s'avère que ces défauts liés à la chambre impactent très lourdement la reproductibilité d'un lot à l'autre et d'une chambre à l'autre.

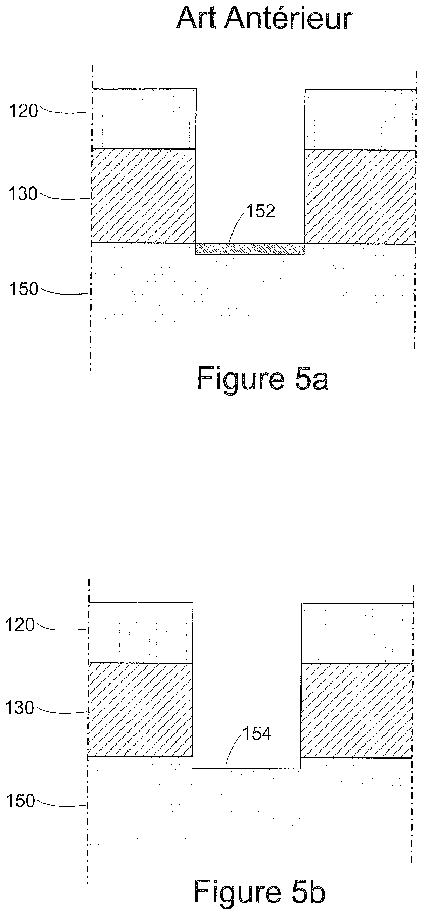

Les figures 5a et 5b illustrent un autre type de défaut lié à la couche 150 qui est située immédiatement sous la couche 130 devant être gravée. La sélectivité de la gravure vis-à-vis du matériau constituant la couche 150 peut être un problème. Comme montré sur la figure 5a celui-ci peut être modifié 152 lors la gravure de la couche 130 s'il est exposé au plasma de gravure.

Certaines gravures requièrent une couche d'arrêt de façon à ce que la gravure s'arrête automatiquement lorsque la couche 130 est complètement gravée. Un arrêt sur le matériau de la couche 150 peut s'avérer être difficile à contrôler si les matériaux des couches 130 et 150 sont de compositions proches ou si l'exposition au plasma de la couche 150 a endommagé la surface 152. Comme montré sur la figure 5b, après l'opération de nettoyage humide mentionnée ci-dessus, on peut alors constater un retrait ou creusement 154 du matériau constituant la couche 150.

Ainsi, avec la réduction de taille des motifs à graver, les contraintes pesant sur les procédés de gravure sont toujours plus grandes. Notamment :
- il faut pouvoir obtenir une sélectivité de gravure élevée, c'est-à-dire avoir un différentiel d'attaque important entre le matériau à graver et le matériau du masque protégeant les parties non gravées ;
- il faut avoir recours de plus en plus souvent à des gravures anisotropes dans lesquelles le taux de gravure vertical doit largement dépasser le taux de gravure latéral ;
- il faut un contrôle plus serré des dimensions critiques et en particulier réduire les dommages induits par le plasma de gravure sur les couches non gravées.

La satisfaction de ces exigences passe par un meilleur contrôle des propriétés du plasma dans un réacteur de gravure sèche. Ce défi qui est relevé pour le noeud technologique actuel de 22 nm en phase de production se pose avec plus d'acuité encore pour les noeuds technologiques en cours de développement au-delà de celui de 22 nm.

Les facteurs critiques à considérer lors des processus de gravure au plasma doivent prendre en compte l'homogénéité des processus de gravure tant à l'échelle macroscopique, c'est-à-dire au niveau d'une tranche, que microscopique, c'est-à-dire au niveau d'une puce. Tous les facteurs mentionnés plus haut doivent concourir à satisfaire cet objectif : rapport entre gravure et déposition des espèces dans le plasma ; vitesse de gravure verticale en fonction de la vitesse de gravure latérale ; contrôle des profils de gravure ; conditionnement et nettoyage des parois du réacteur ; formation de la couche de passivation protégeant les flancs des motifs gravés ; réduction des dommages induits par le plasma sur les couches non gravées.

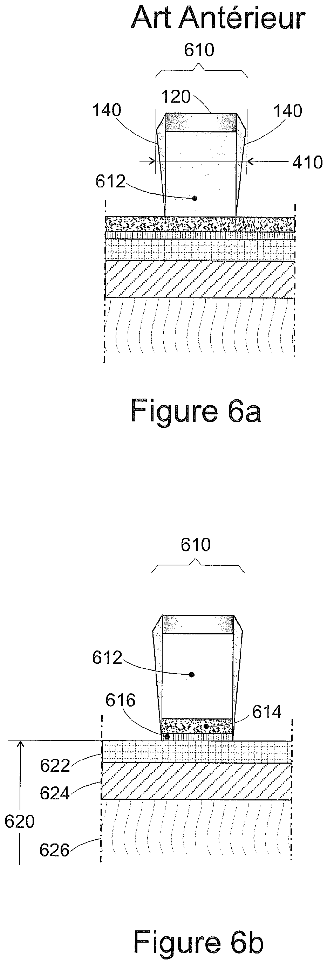

Les figures 6a à 6f illustrent comment les problèmes liés à la gravure plasma, exposés dans les figures précédentes, se posent plus spécifiquement lors de la réalisation de transistors MOSFET de type FDSOI, acronyme de l'anglais faisant référence à un procédé technologique, largement utilisé actuellement pour la fabrication de circuits intégrés, où l'on réalise les transistors avec des canaux de conduction qui peuvent être complètement désertés de leurs porteurs ou « fully depleted » (FD). Pour obtenir ce résultat on part alors de substrats élaborés de type silicium sur isolant ou « silicon on insulator » (SOI) à la surface desquels les transistors sont réalisés à partir d'une fine couche de silicium monocristallin.

La figure 6a montre la réalisation de la grille 610 d'un tel transistor en cours de fabrication après gravure de la couche 612 de silicium polycristallin faisant partie de l'empilement de couches constituant la grille de contrôle d'un transistor MOSFET de type FDSOI. Comme on l'a vu précédemment, il y a formation d'une couche de passivation 140 de part et d'autre du motif de grille qui est protégé par le masque dur 120. À ce stade, l'enjeu est de satisfaire les dimensions critiques 410 du noeud technologique correspondant en dépit de la formation de la couche de protection qui affecte, comme on l'a vu dans les figures précédentes, la précision de définition des motifs gravés.

La figure 6b illustre la gravure des autres couches formant la grille 610. L'empilement de couches formant la grille comprend notamment la fine couche isolante d'oxyde de grille 616 à travers laquelle un champ électrique va pouvoir se développer quand une tension électrique suffisante est appliquée en fonctionnement sur celle-ci. Ceci afin de créer un canal de conduction sous la grille, entre les électrodes de source et drain qui vont être formés ensuite de part et d'autre. Dans les transistors MOSFET les plus récents il est mis en oeuvre une technologie qualifiée du vocable anglais de « high-k/metal gate » c'est-à-dire que la couche diélectrique 616 est faite d'un matériau isolant à haute permittivité (high-k) couverte par une grille métallique (metal gate) représentée par la couche 614. Le risque au cours de cette étape est alors, comme on l'a vu dans les figures précédentes, d'endommager la mince couche 622 de silicium monocristallin qui est mise à nue lors de la gravure. Celle-ci constitue la couche superficielle du substrat SOI 620 à partir duquel les transistors de type FDSOI sont réalisés. La couche superficielle 622 repose sur une couche continue d'oxyde 624 dite BOX, acronyme de l'anglais « buried oxide layer » c'est-à-dire « couche d'oxyde enterré ». La solidité et la rigidité mécanique de l'ensemble sont assurées par la couche 626 qui constitue le corps du substrat SOI, souvent qualifié du vocable anglais de « bulk » pour indiquer que le substrat de départ est très généralement fait de silicium massif. Cette structure offre de nombreux avantages pour la réalisation des transistors MOSFET. Notamment, elle permet une réduction drastique des capacités parasites en raison de la présence de la couche continue isolante 624. La couche superficielle de silicium monocristallin 622 peut être contrôlée précisément en épaisseur et en dopage. En réalisant des couches très minces le canal de conduction entre source et drain peut être alors effectivement être complètement déserté de porteurs (FD) ce qui est très avantageux pour les performances électriques des transistors que l'on réalise selon cette technique (FDSOI). Ceci n'est pas sans conséquence cependant vis-à-vis de la gravure plasma qui peut endommager d'autant plus facilement cette couche qu'elle est mince voire très mince et ainsi compromettre les opérations suivantes de formation des électrodes de source et drain de part et d'autre de la grille.

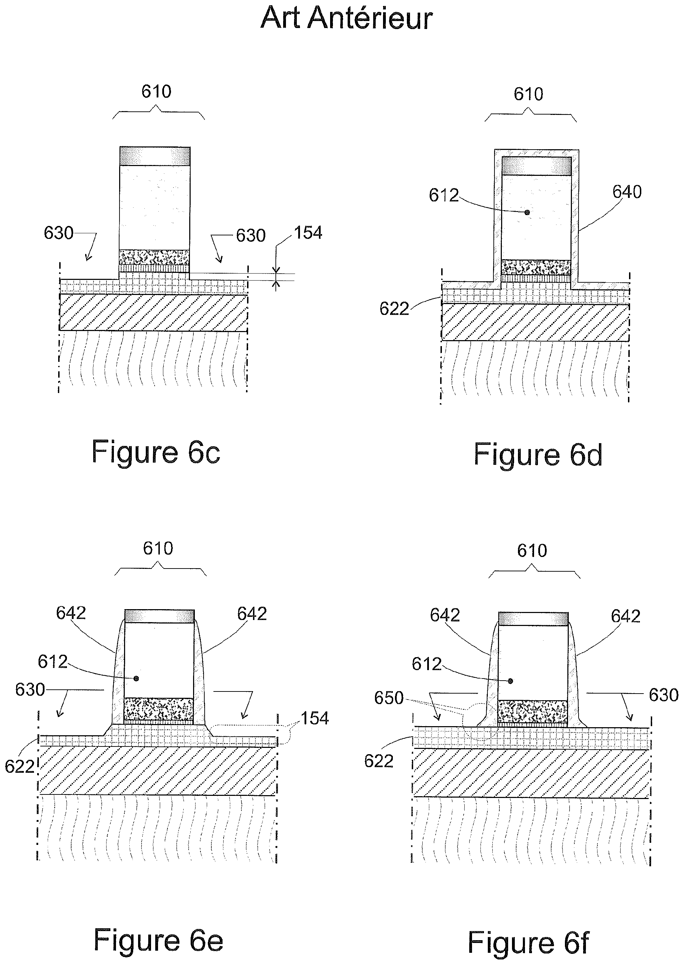

La figure 6c illustre ces inconvénients. Comme on l'a vu dans les figures précédentes l'opération suivante de nettoyage humide destinée à enlever la couche de passivation va aussi attaquer, dans les zones de source et drain 630 de part et d'autre de la grille 610, la mince couche de silicium monocristallin qui aura été endommagée ou partiellement gravée par les opérations de gravure plasma des couches formant la grille en raison de la faible sélectivité entre matériaux différents de ce type de gravure. On constate alors un retrait 154 du silicium dans ces zones.

La figure 6d illustre l'étape conventionnelle suivante de la réalisation de transistors FDSOI dans laquelle on procède au dépôt d'une couche 640 devant servir à la formation d'espaceurs. Comme montré sur les figures 6e et 6f la partie de la couche 640 qui reste en place de part et d'autre de la grille après gravure anisotrope de celle-ci forme effectivement les espaceurs 642 entre la grille et les électrodes de source et drain (non représentées).

La formation des espaceurs 642 est devenue une étape cruciale de formation des transistors de type FDSOI de tailles décananométriques. La réalisation des espaceurs est de préférence auto alignée sur la grille 610 à partir du dépôt, comme illustré sur la figure 6d, d'une couche uniforme 640, par exemple de nitrure de silicium, qui subit ensuite une gravure plasma très fortement anisotrope afin de ne laisser en place que les motifs 642.

Cependant, étant donné les limitations et imperfections de la gravure plasma discutées ci-dessus, on peut observer deux types de défauts principaux à l'issue de la formation des espaceurs 642. Comme déjà mentionné, on peut constater, comme illustré sur la figure 6e, un retrait ou creusement 154 de la couche superficielle qui laisse en place une épaisseur insuffisante de silicium pour les opérations suivantes notamment pour l'épitaxie destinée à la formation des électrodes de source et drain surélevés (non représentés).

Comme illustré sur la figure 6f, on peut aussi observer au contraire une gravure insuffisante et la formation de « pieds » 650 au bas des espaceurs qui vont affecter les performances électriques des transistors de type FDSOI en modifiant la longueur du canal.

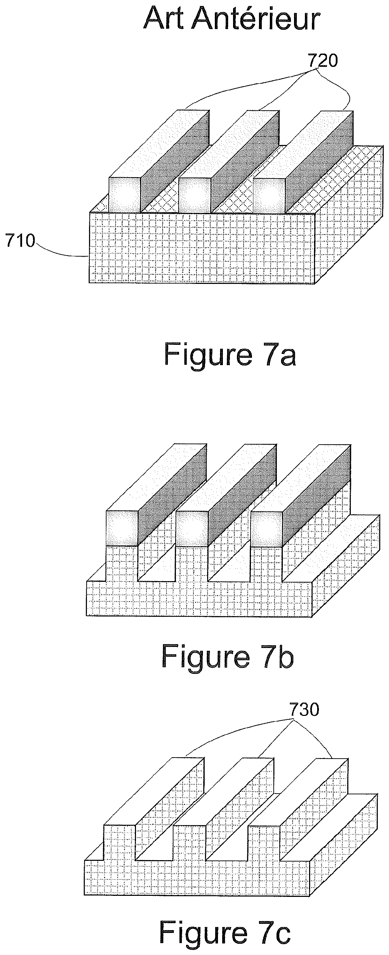

Les figures 7a à 7i illustrent comment les problèmes liés à la gravure plasma, exposés dans les figures 2 à 5, se posent plus spécifiquement lors de la réalisation de transistors MOSFET de type FinFET, une autre structure de transistor qui commence à être utilisée par l'industrie de la microélectronique pour les noeuds technologiques à partir de celui de 22 nm. Dans la structure FinFET le canal de conduction est constitué d'une mince lamelle verticale de silicium, qualifiée du terme anglais de « fin » c'est-à-dire de « nageoire ». Il est entouré sur trois côtés par la grille de commande. Cela permet d'obtenir des transistors ayant de meilleures performances électriques et aussi de réduire les courants de fuite.

Les figures 7a à 7i décrivent les étapes principales de formation d'un transistor FINFET. Les figures 7a, 7b et 7c illustrent plus particulièrement la formation par gravure d'une couche 710 d'un semi-conducteur cristallin, le plus souvent du silicium, des motifs tridimensionnels, c'est-à-dire les « fins », qui vont former les canaux de conduction 730 des transistors. La forme des canaux est définie par un masque dur 720 qui est transféré par gravure dans la couche 710. Cette couche est par exemple la couche superficielle de silicium monocristallin d'un substrat SOI déjà décrit et repose donc sur une couche continue d'oxyde et un substrat (non représentés).

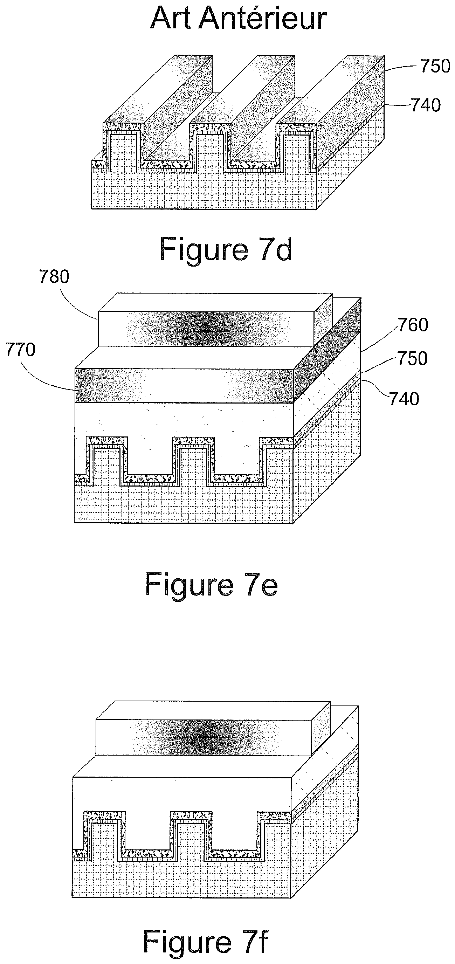

Les figures 7d, 7e et 7f illustrent la formation de la grille des transistors. Comme avec les transistors de type FDSOI la grille est constituée d'un empilement de couches que l'on vient successivement déposer sur les motifs 730 qui vont constituer les canaux. On retrouve donc la fine couche isolante d'oxyde de grille 740 et la couche 750 faite d'un matériau isolant à haute permittivité (high-k) couverte par une grille métallique (metal gate). Le tout est recouvert par une couche de silicium polycristallin 760 qui a été aplanie et sur laquelle on dépose et définit par photolithographie les masques durs 770 et 780 qui vont permettre par gravure de l'empilement des couches ci-dessus de former la grille ainsi que les électrodes source et drain des transistors.

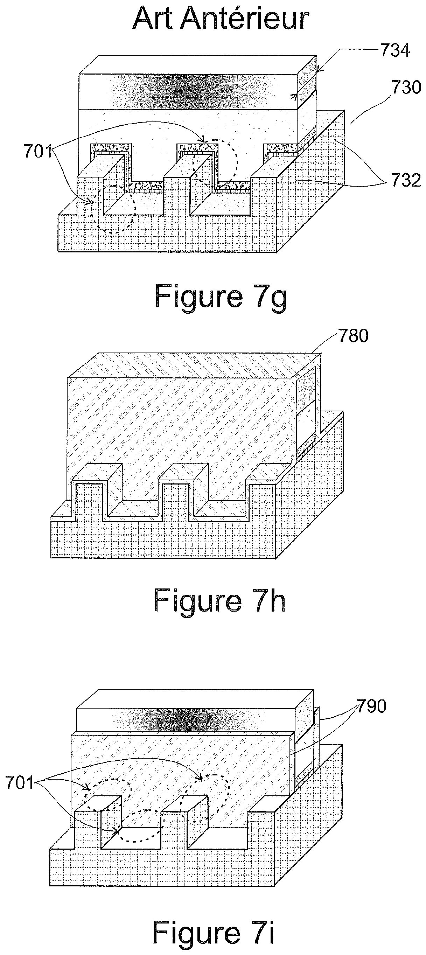

Les figures 7g, 7h et 7i illustrent les opérations suivantes où l'on procède à la gravure des couches de grille ce qui permet de libérer, à partir de chaque motif 730, les zones de source et de drain 732 de part et d'autre de la grille et de définir la longueur des canaux 734. Comme avec les transistors de type FDSOI on a aussi besoin d'espaceurs. Ils sont obtenus, après dépôt d'une couche continue 780 faite généralement de nitrure de silicium, à l'aide d'une gravure très anisotrope de cette couche qui ne laisse en place que les motifs verticaux 790 sur les flancs de la grille.

Comme les transistors FDSOI, les transistors de type FinFET souffrent donc pour leur réalisation des limitations et imperfections de la gravure plasma. En particulier, pour réaliser cette structure de transistor, la gravure utilisée doit avoir une excellente sélectivité vis-à-vis du silicium (Si) et de son oxyde (SiO2) ce qui est difficile à obtenir, comme on l'a vu, avec une gravure plasma. Comme indiqué sur les figures 7g et 7i l'intégrité des angles des motifs gravés en est affectée. En effet, pour que le transistor FinFET présente de bonnes performances, les arêtes 701 des «fins» doivent former des angles qui soient les plus droits possible, tout arrondi de ces angles entraînant une réduction des performances du transistor. Il en est de même pour l'angle que forme les espaceurs et la couche sur laquelle elle repose, typiquement la couche de silicium. Cet angle est indiqué en pointillé sur la figure 7i.

Pour les raisons indiquées ci-dessus, les solutions actuelles reposant sur les gravures plasma ne permettent pas d'obtenir des arêtes formant des angles droits.

On voit donc que la gravure plasma, si elle a permis de suivre les réductions de taille des motifs à chaque introduction d'un nouveau noeud technologique dans les années passées, pose cependant de plus en plus de problèmes quand la taille diminue, en particulier au-delà du noeud technologique de 22 nm. La mise en oeuvre de la gravure plasma pour ces dimensions introduit un degré de complexité supplémentaire pour essayer de pallier les problèmes décrits ci-dessus. Des chimies de gravure plus complexes que celle traditionnelle, dite fluorocarbonée, ont été testées qui nécessitent d'introduire des gaz supplémentaires dans la chambre de gravure. Jusqu'à cinq gaz différents ont été combinés pour former le plasma de gravure. Cela a pour conséquence première d'accroître le nombre de paramètres, déjà fort nombreux, qu'il faut pouvoir contrôler et rend encore plus difficile un réglage optimal de la gravure.

Un autre type d'approche consiste à baisser la température des électrons du plasma. Ceci peut être obtenu à l'aide d'au moins deux méthodes. L'une dans laquelle la source de radiofréquences utilisée pour créer le plasma n'est pas établie continuellement mais puisée. On obtient un plasma plus froid dans lequel l'énergie des électrons est seulement de quelques électrons-volts (eV) voire inférieure à 1 eV. L'avantage d'un plasma plus froid est qu'il provoque moins de dommages aux matériaux gravés. L'autre méthode pour obtenir un plasma plus froid consiste à utiliser une source de radiofréquence micrométrique. Les électrons acquièrent alors une énergie dans une gamme allant de 1 à 2 eV. Un tel type de plasma est décrit par exemple dans la publication suivante en langue anglaise :
- « Microwave plasma », Shinichi Tachi et al., J. Vac. Sci. Technol. A 9, 796 (1991). On note toutefois que ce type de plasma donne une gravure peu uniforme et impose des temps de gravure qui sont longs
Sur le sujet des plasmas pulsés on pourra se référer aux deux publications suivantes en anglais :
- « Pulsed high-density plasmas for advanced dry etching processes », Banna et al, J. Vac. Sci. Technol. A 30(4), July/August 2012. Cette publication résume bien les défis posés par la mise au point d'un plasma de gravure et décrit plus particulièrement les plasmas pulsés et leurs avantages.
- « Silicon recess minimization during gate patterning using synchronous plasma pulsing », Petit-Etienne et al, J. Vac. Sci. Technol. B, Vol. 30, No. 4, Jul/Aug 2012.

On notera toutefois que les plasmas pulsés n'apportent pas une réponse à tous les problèmes posés. Notamment, si les plasmas pulsés améliorent bien le caractère anisotrope des profils de gravure et la sélectivité entre matériaux, au prix toutefois d'une chimie de gravure complexe, ils n'ont qu'un impact très limité sur le retrait ou creusement décrit, par exemple, dans la figure 6e.

De manière générale on remarquera qu'il est très difficile de contrôler la gravure plasma d'un matériau en s'arrêtant sur une couche sous-jacente sans endommager cette dernière sur quelques nanomètres. La gravure plasma entraîne en effet la formation et la propagation, au fur et à mesure de la gravure, d'une couche réactive sur une profondeur qui est typiquement de plusieurs nanomètres. En particulier, si le matériau sous-jacent est du silicium monocristallin, ce qui est le cas pour la gravure des espaceurs des transistors de type FinFET ou FDSOI faits de nitrure, il est difficile voire impossible de graver complètement le nitrure tout en s'arrêtant sur le silicium sans l'endommager. L'épaisseur de la couche réactive fait que celle-ci s'étend toujours en pratique dans la couche sous-jacente pour l'endommager en surface et/ou la graver partiellement. Ceci se produit d'autant plus que l'on doit ajouter généralement un temps de « surgravure » plus ou moins important au-delà du temps nécessaire à la gravure des surfaces planes pour s'assurer que les angles intérieurs des motifs à graver l'ont été complètement. Ce problème se pose donc plus particulièrement pour les transistors de type FinFET en raison de la structure tridimensionnelle de ces transistors comme déjà discuté ci-dessus.

On voit donc que pour graver des motifs de tailles toujours plus réduites les solutions connues basées sur une gravure par voie humide ou sur une gravure plasma présentent de nombreux inconvénients.

On connaît aussi des procédés dans lesquels on implante des ions légers dans un matériau avant de retirer la partie implantée. Dans US 2007 / 243 700 par exemple, on implante du Bore. Dans WO 2012 /166 850, on implante du carbone.

C'est donc un objet de l'invention que de décrire une nouvelle méthode de gravure qui limite au moins certains des inconvénients mentionnés ci-dessus des solutions connues de gravure par voie humide ou de gravure plasma.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Selon un premier mode de réalisation, l'invention concerne un procédé microélectronique de gravure d'un matériau d'une couche à graver, comprenant les étapes successives suivantes:
- modification de la couche à graver depuis la surface de la couche à graver et sur une profondeur correspondant à une portion au moins de l'épaisseur de la couche à graver de manière à former un film modifié, la modification comprenant l'implantation d'ions légers dans la couche à graver;
- l'implantation est réalisée à partir d'un plasma comprenant les ions légers, les ions légers étant pris parmi l'hélium et l'hydrogène.
- retrait du film modifié sélectif par rapport à au moins une couche sous-jacente au film et au contact de ce dernier.

Ainsi, le film formé par la modification de la couche initiale est éliminé lors de l'étape de retrait.

Il s'est avéré qu'en mettant en oeuvre ce procédé, on obtient une sélectivité de gravure significativement augmentée, permettant de ce fait d'améliorer la précision de la gravure et le contrôle de l'épaisseur gravée.

Par ailleurs, cette sélectivité améliorée est obtenue sans impact significatif sur les parois du réacteur dans lequel le plasma est effectué, permettant ainsi de réduire les problèmes de reproductibilité constatés avec les solutions connues.

En outre, ce procédé permet d'obtenir une gravure fortement anisotrope si l'implantation est réalisée selon une direction privilégiée.

Selon un autre mode de réalisation, l'invention concerne un procédé microélectronique de gravure d'une couche à graver, comprenant les étapes suivantes:
- modification d'une portion au moins de la couche à graver par implantation dans la couche à graver d'espèces, choisies parmi les ions légers, ces ions légers étant pris parmi l'hélium et l'hydrogène, répartis de manière ininterrompue depuis la surface et jusqu'à une profondeur correspondant à une portion au moins de l'épaisseur de la couche à graver, de manière à former un film,
- retrait du film modifié comprenant une gravure sélective du film par rapport à au moins une couche sous-jacente au film.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les figures 1a à 1c illustrent un mode de gravure standard isotrope.
Les figures 2a à 2d illustrent un mode de gravure standard anisotrope.
La figure 3 discute le fonctionnement d'un plasma de gravure conventionnel.
Les figures 4a et 4b montrent la formation d'une couche de passivation lors d'une gravure plasma et discutent ses inconvénients.
Les figures 5a et 5b illustrent d'autres inconvénients liés à la gravure plasma.
Les figures 6a à 6f montrent les étapes de formation d'un transistor MOSFET de type FDSOI.
Les figures 7a à 7i montrent les étapes de formation d'un transistor MOSFET de type FinFET.
La figure 8 montre les étapes d'un exemple de procédé de gravure selon l'invention.
Les figures 9a à 9c illustrent le résultat des étapes de gravure selon un exemple de procédé de mise en oeuvre de l'invention sur les couches de matériaux exposées à la gravure.
Les figures 10a et 10b illustrent, respectivement, les conditions de fonctionnement d'un plasma et celles d'un implanteur pouvant être utilisés pour l'implantation d'espèces légères selon des exemples de réalisation de l'invention.
Les figures 11a et 11b montrent la modification de la couche à graver après implantation d'espèces légères respectivement à l'aide d'un plasma et d'un implanteur.
La figure 12 illustre différentes options de retrait de la couche modifiée dans un procédé de réalisation de l'invention.
La figure 13 montre les étapes d'un retrait de la couche modifiée par sublimation de sels solides.
Les figures 14a à 14e montrent l'évolution des épaisseurs modifiées d'un matériau à graver en fonction des conditions de formation du plasma d'implantation.
Les figures 15a à 15c montrent des courbes similaires pour le silicium.
Les figures 16a à 16c concernent l'emploi d'espèces légères autres que l'hydrogène et l'hélium.
La figure 17 concerne la gravure de métaux avec oxydation.
   Les figures18a et 18b comparent les profondeurs d'implantation d'ions dans du nitrure de titane (TiN).
Les figures 19a et 19b illustrent, pour les métaux, l'amélioration d'efficacité apportée par une oxydation lors du retrait d'une couche modifiée.
Les figures 20a à 20d décrivent un exemple de procédé selon l'invention quand il est appliqué à la gravure anisotrope de motifs définis par un masque dur.
Les figures 21a à 21f décrivent un exemple de procédé selon l'invention quand il est appliqué à la gravure anisotrope de motifs dans le cas où la gravure n'est pas sélective vis-à-vis du masque dur.
Les figures 22a à 22c complètent les figures 20a à 20d et illustrent le cas où le masque dur n'est pas consommé lors de l'opération de retrait des couches modifiées.
Les figures 23a à 23c illustrent le concept général de gravure isotrope et anisotrope qu'il faut pouvoir mettre en oeuvre en microélectronique.
Les figures 24a à 24c illustrent le cas d'une gravure effectuée à partir d'un plasma de type par immersion qui a été paramétré pour que l'implantation se fasse de façon isotrope.
Les figures 25a et 25b illustrent le cas où l'implantation des espèces légères dans un plasma est directionnelle.
Les figures 26a à 26f décrivent une option de modification de la couche à graver qui s'applique dans le cas d'utilisation d'un implanteur et d'un faisceau d'ions directionnel afin d'obtenir une gravure isotrope.
La figure 27 illustre une option supplémentaire de retrait 820 de la couche modifiée.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des différentes couches et films ne sont pas représentatives de la réalité.

### DESCRIPTION DÉTAILLÉE DE L'INVENTION

Il est précisé que dans le cadre de la présente invention, le terme « sur », « surmonte » ou « sous jacent » ou leurs équivalent ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

Dans la description qui suit, les épaisseurs sont généralement mesurées selon des directions perpendiculaires au plan de la face inférieure de la couche à graver ou d'un substrat sur lequel la couche inférieure est disposée. Ainsi, les épaisseurs sont généralement prises selon une direction verticale sur les figures représentées. En revanche l'épaisseur d'une couche recouvrant un flanc d'un motif est prise selon une direction perpendiculaire à ce flanc.

Avant d'entamer une revue détaillée de modes de réalisation de l'invention, sont énoncées ci-après des caractéristiques optionnelles qui peuvent éventuellement être utilisées en association ou alternativement :
Avantageusement, l'implantation est effectuée de manière à ce que les ions implantés soient répartis de manière ininterrompue depuis la surface de la couche à graver et jusqu'à ladite profondeur. Cette répartition ne présente pas de discontinuité. Il n'y a donc pas de couches où les espèces implantées sont absentes entre la surface de la couche à graver et la profondeur maximale d'implantation. Cette répartition peut être homogène ou non homogène. Typiquement cette répartition va décroissante depuis la surface de la couche à graver et jusqu'à ladite profondeur.

Selon un mode de réalisation particulièrement avantageux, l'implantation est réalisée à partir d'un plasma.

L'implantation par plasma a pour avantage de permettre une implantation de manière continue dans un volume s'étendant dès la surface de la couche implantée.

En outre l'utilisation d'un plasma permet une implantation à des profondeurs plus faibles que les profondeurs minimales que l'on peut obtenir avec des implanteurs. Ainsi, une implantation par plasma permet d'implanter efficacement et de manière relativement homogène ou tout au moins de manière continue des épaisseurs fines que l'on peut ensuite retirer par une gravure sélective. Cette continuité d'implantation depuis la face implantée permet d'améliorer l'homogénéité de la modification selon la profondeur, ce qui conduit à une vitesse de gravure constante dans le temps de la couche implantée. Par ailleurs, l'augmentation de la sélectivité conférée par l'implantation vis à vis des autres couches est effective dès le début de la gravure de la couche implantée. L'implantation par plasma permet ainsi un contrôle significativement amélioré de la précision de gravure.

L'implantation plasma permet typiquement d'implanter puis de retirer des épaisseurs s'étendant depuis la surface de la couche implantée et sur une profondeur allant de 0 nm à 100nm. Les implanteurs classiques, permettent une implantation dans un volume compris entre 30 nm et plusieurs centaines de nanomètres. En revanche, les implanteurs classiques ne permettent pas d'implanter les espèces entre la surface de la couche à implanter et une profondeur de 30nm. Dans le cadre du développement de la présente invention, il a été remarqué que les implanteurs ne permettent alors pas d'obtenir une vitesse de gravure suffisamment constante de la couche modifiée et ce depuis la surface de cette dernière, conduisant ainsi à une moindre précision de gravure comparé à ce que permet l'invention.

L'utilisation d'un plasma pour modifier la couche à retirer est donc particulièrement avantageuse dans le cadre de l'invention qui vise à retirer une fine épaisseur, typiquement comprise entre 1 et 10 nm et plus généralement entre 1 et 30 nm.

L'étape de modification réalisée à partir d'un plasma modifie la couche à graver de manière continue depuis la surface de cette couche et sur une épaisseur comprise entre 1 nm et 30nm et de préférence entre 1nm et 10 nm.

Selon un mode de réalisation particulièrement avantageux, l'implantation et le retrait de la couche à graver sont réalisées dans un même réacteur plasma. Une modification de la couche à retirer réalisée par une implantation par plasma permet ainsi d'effectuer la modification de la couche et la gravure dans une même chambre ce qui est très avantageux en termes de simplification, de temps et de coût du procédé.

Avantageusement, cette implantation d'ions ne grave pas le matériau n'entraînant pas de redepôt du matériau sur les flancs des motifs ou sur les parois du réacteur permettant, d'une part, d'obtenir un meilleur contrôle des dimensions critiques des motifs gravés et, d'autre part, d'acquérir une indépendance de la gravure vis-à-vis du conditionnement des parois du réacteur.

Avantageusement, l'obtention précise d'une profondeur souhaitée d'implantation, par contrôle de l'énergie des ions et de leur dose, n'entraîne pas la formation d'une couche réactive comme dans les procédés standards de gravure plasma évitant ainsi les inconvénients mentionnés précédemment.

Avantageusement, les paramètres d'implantation, en particulier l'énergie communiquée aux ions, la durée et la dose d'implantation sont prévus de sorte que le film puisse être gravé sélectivement par rapport à la au moins une couche sous jacente au film. Ces paramètres sont également réglés de manière à ce que le film puisse être gravé sélectivement par rapport à la portion non modifiée de la couche à graver.

Avantageusement, les ions sont choisis de sorte que le film est susceptible d'être gravé sélectivement vis-à-vis de la couche qui lui est sous-jacente.

On entend par « ions légers » des ions provenant de l'hélium (H) ou de l'hydrogène (H2). Ces ions peuvent être implantés dans le matériau à graver, sans provoquer de dislocation de sa structure atomique telle qu'elle entraînerait une pulvérisation de ce dernier, et donc sans redépôt du matériau gravé sur les parois du réacteur ou les motifs en cours de gravure eux-mêmes.

Les ions légers sont pris parmi l'hydrogène (H2) et l'hélium (He) dont les numéros atomiques sont respectivement 1 et 2.

Selon un mode de réalisation, l'implantation est réalisée de manière anisotrope, selon au moins une direction d'implantation sensiblement perpendiculaire au plan dans lequel s'étend la couche à graver ou un substrat sur lequel est disposé la couche à graver.

Selon un mode de réalisation, ladite couche sous-jacente au film est une portion de la couche à graver qui n'a pas été modifiée par l'implantation. Alternativement, ladite couche sous-jacente au film est une couche additionnelle présente sous la couche à graver avant l'étape de modification.

Selon un mode de réalisation, la couche à graver est faite d'un matériau à base d'un matériau semi-conducteur comprenant : le silicium (Si), le germanium (Ge), le silicium germanium (SiGe). Selon un mode de réalisation, la couche à graver est faite d'un matériau à semi-conducteur composite de type III-V et II-VI obtenu en combinant, respectivement, deux éléments, ou plus, des colonnes II et III d'une part, et V et VI d'autre part, du tableau périodique des éléments. Selon un mode de réalisation, la couche à graver est un oxyde ou un nitrure d'un matériau semi-conducteur pris parmi la liste ci-dessus.

Alternativement, la couche à graver est un oxyde métallique ou du carbone dopé au bore (B:C). Alternativement, la couche à graver est un métal ou un alliage de métaux.

Selon un mode de réalisation, la modification comprend, avant l'implantation des ions, une oxydation d'une partie de la couche à graver depuis sa surface. La partie de la couche à graver qui est oxydée s'étend depuis la surface de la couche à graver et sur une profondeur inférieure ou égale à l'épaisseur dudit film formant la portion modifiée de la couche à graver. Ce mode de réalisation a pour avantage d'augmenter l'épaisseur du film oxydé et modifié par implantation d'ions légers. Le retrait de la couche modifiée est ainsi facilité sans pénaliser la productivité.

Selon un autre mode de réalisation, la modification comprend, après l'implantation des ions et avant le retrait du film, une oxydation d'une partie de la couche à graver depuis sa surface. De préférence, la partie de la couche à graver qui est oxydée s'étend depuis la surface de la couche à graver et sur profondeur sensiblement égale à l'épaisseur dudit film. Ce mode de réalisation a pour avantage d'augmenter l'épaisseur du film oxydé et modifié par implantation des ions. Le retrait de la couche modifiée est ainsi facilité sans pénaliser la productivité. Ce film alors oxydé est alors retiré plus facilement que s'il n'était que modifié par la seule l'implantation d'ions légers.
Selon encore un autre mode de réalisation, la modification est réalisée par un plasma comprenant de l'oxygène et des ions légers. La modification de la couche à graver comprend donc simultanément une oxydation et une implantation d'ions légers. Ce mode de réalisation a pour avantage d'augmenter l'épaisseur du film oxydé et modifié par implantation des ions. Le retrait de la couche modifiée est ainsi facilité sans pénaliser la productivité. En particulier, le film formé par la couche à graver ainsi modifiée se retire plus facilement que s'il n'était que modifié par seulement une implantation d'ions légers.
De préférence, dans ces cas, le matériau de la couche à graver est du métal ou un alliage de métaux.

Selon un mode de réalisation, la modification de la couche à graver est effectuée sur une profondeur correspondant à une portion seulement de l'épaisseur de la couche à graver, de manière à ce que le retrait du film retire une portion seulement de l'épaisseur de la couche à graver. Selon un autre mode de réalisation, la couche à graver est effectuée sur une profondeur correspondant à toute l'épaisseur de la couche à graver, de manière à ce que le retrait du film retire toute la couche à graver. Ainsi, la gravure du film se fait préférentiellement sur la couche modifiée formant le film par rapport à la couche disposée, avant l'étape de modification, au contact de la couche à graver.

Selon un mode de réalisation, l'étape de retrait du film comprend au moins l'une des étapes suivantes : une étape de nettoyage par voie humide, une étape de nettoyage par voie sèche. De préférence, l'étape de retrait du film comprend au moins une étape de gravure en phase vapeur avec un gaz réagissant avec le film pour former un produit de réaction volatil.

### gravure à travers un masque

Selon un mode de réalisation particulier, l'implantation dans la couche à graver est effectuée à travers un masque. L'implantation est effectuée selon une direction privilégiée qui est perpendiculaire à un plan dans lequel le masque s'étend. De préférence, le masque est un masque dur. Le masque présente des ouvertures définissant des motifs. De préférence, l'implantation est effectuée pleine plaque, c'est-à-dire dans les ouvertures du masque et hors de ces ouvertures.

Selon un mode de réalisation, on effectue plusieurs cycles comprenant chacun une implantation dans la couche à graver à travers le masque et un retrait du film par gravure sélective du film par rapport au moins à la portion non modifiée de la couche à graver. Ainsi, à l'issue de la pluralité de cycles, on a gravé la couche à graver sur une épaisseur supérieure à la profondeur d'implantation de chaque cycle.

### gravure à travers un masque sans sélectivité par rapport au masque

Selon un mode de réalisation, l'étape de retrait est effectuée de manière à ce que la gravure grave le film sans sélectivité par rapport au masque, de manière à graver lors du retrait une épaisseur de masque sensiblement égale à l'épaisseur du film. On prévoit alors une épaisseur initiale de masque au moins égale à la profondeur totale de la couche à graver que l'on souhaite retirer.

### gravure à travers un masque avec sélectivité par rapport au masque

Selon un autre mode de réalisation, l'étape de retrait est effectuée de manière à ce que la gravure grave le film préférentiellement au masque, de manière à ne pas consommer le masque lors de l'étape de retrait ou de manière à consommer une épaisseur de masque inférieure à l'épaisseur du film lors de l'étape de retrait.

Selon un mode de réalisation particulier, la couche à graver recouvre des motifs présentant des flancs et l'implantation des ions est réalisée de manière anisotrope selon au moins une direction qui est sensiblement parallèle audits flancs. Plus précisément, les flancs définissent des plans sensiblement parallèles les uns aux autres et la direction privilégiée de l'implantation anisotrope est parallèle à ces plans. Ainsi, le film formé par la couche à graver modifiée s'étend essentiellement perpendiculairement aux flancs. Le film ne s'étend pas sur toute la hauteur des flancs. Ainsi, l'étape de retrait laisse en place une épaisseur de couche à graver plus importante au niveau des flancs des motifs qu'en dehors des flancs.

### gravure anisotrope, conservation des espaceurs

Selon un mode de réalisation particulier, l'implantation d'ions est réalisée de manière anisotrope selon une unique direction qui est sensiblement parallèle audits flancs.

Selon un mode de réalisation particulier la modification de la couche à graver est effectuée sur une profondeur correspondant à toute l'épaisseur de la couche à graver prise selon une direction perpendiculaire à la direction de l'implantation anisotrope, de manière à ce que le retrait du film retire toute la couche à graver en dehors des flancs des motifs et laisse en place au moins une partie de la couche à graver recouvrant les flancs des motifs. Le procédé selon l'invention offre ainsi une solution fiable et très précise pour former une couche sur les flancs des motifs. Elle trouve ainsi une application particulièrement avantageuse pour la formation d'espaceurs disposés par exemple sur les flancs d'une grille de transistor.

Selon un mode de réalisation, les motifs sont formés dans un premier matériau et au-dessus d'une couche en un second matériau, la couche à graver étant, avant l'étape de modification, au contact du premier matériau au niveau des motifs et au contact du deuxième matériau en dehors des motifs, l'étape d'implantation et l'étape de retrait étant opérées de manière à graver le film sélectivement au premier matériau et au deuxième matériau.

### gravure isotrope ou plusieurs gravures anisotropes

Selon une première alternative, la couche à graver forme des motifs et l'implantation d'ions est réalisée de manière isotrope. Cette implantation est réalisée à partir d'un plasma par immersion.

Selon une autre alternative, l'implantation d'ions est réalisée de manière anisotrope selon au moins deux directions différentes.

De préférence, l'implantation d'ions comprend au moins une autre implantation réalisée de manière anisotrope selon au moins une direction non parallèle à au moins certains des flancs des motifs, de manière implanter des ions dans lesdits flancs et de manière à retirer, lors de l'étape de retrait, la couche à graver s'étendant en dehors desdits flancs des motifs et au moins une partie de la couche à graver recouvrant lesdits flancs.

Selon un mode de réalisation, l'implantation d'ions comprend une première implantation anisotrope réalisée selon une direction sensiblement perpendiculaire à une couche sur laquelle les motifs sont situés, une deuxième implantation réalisée selon une direction non parallèle à des premiers flancs des motifs et de manière à implanter des ions dans les premiers flancs, une troisième implantation réalisée selon une direction non parallèle à des deuxièmes flancs des motifs et de manière à implanter des ions dans les deuxièmes flancs, les étapes d'implantation et de retrait étant effectuées de manière à retirer, lors de l'étape de retrait, la couche à graver située en dehors des flancs des motifs et une partie au moins de la couche à graver recouvrant les premiers et les deuxièmes flancs.

### plusieurs gravures anisotropes, amincissement des espaceurs

Selon un premier mode de réalisation, l'au moins une autre implantation est réalisée de manière à modifier la couche à graver recouvrant lesdits flancs sur une profondeur correspondant à une portion seulement de l'épaisseur de la couche à graver recouvrant lesdits flancs. Ainsi, lors de l'étape de retrait, une partie de la couche à graver est conservée sur lesdits flancs. Le procédé selon l'invention offre ainsi une solution fiable et très précise pour former une couche d'épaisseur contrôlée sur les flancs des motifs. Elle trouve ainsi une application particulièrement avantageuse pour la formation d'espaceurs, de nitrure par exemple, disposés par exemple sur les flancs d'une grille de transistor.

### plusieurs gravures anisotropes, retrait complet de la couche à graver

Selon un autre mode de réalisation, l'au moins une autre implantation est réalisée de manière à modifier la couche à graver recouvrant lesdits flancs sur une profondeur correspondant à toute l'épaisseur de la couche à graver recouvrant lesdits flancs. Ainsi, lors de l'étape de retrait, toute la couche à graver est retirée sur lesdits flancs. Lesdits flancs sont ainsi mis à nu.

### réalisation d'espaceurs de nitrure

Selon un mode de réalisation particulier au moins un motif est une grille d'un transistor située au-dessus d'une couche en un matériau semi-conducteur. La couche à graver est avantageusement une couche de nitrure de silicium recouvrant le motif et la couche en un matériau semi-conducteur. L'étape de modification est effectuée de manière à implanter des ions sur toute l'épaisseur de la couche de nitrure de silicium située en périphérie de la grille et éventuellement sur une portion de l'épaisseur de la couche de nitrure de silicium située sur des flancs de la grille. Les étapes d'implantation et de retrait du film sont effectuées de manière à graver le film sélectivement au matériau semi-conducteur et au nitrure de silicium non modifiée.

L'invention permet ainsi de conserver au moins une partie du nitrure de silicium sur les flancs de la grille. On obtient ainsi des espaceurs en nitrure de silicium dont les épaisseurs sont contrôlées avec précision et sans dégrader la couche en matériau semi-conducteur sous-jacente.

De préférence, l'étape de modification de la couche de nitrure de silicium est précédée d'une étape principale de gravure anisotrope comprenant une gravure sèche dans un plasma à base de fluorure de méthyle (CH3F).

De préférence le matériau semiconducteur est un matériau à base de silicium.

Selon un mode de réalisation particulier, l'étape de retrait du film formé de la couche de nitrure de silicium implantée est effectuée par gravure humide sélective audit matériau semiconducteur, obtenue à l'aide d'une solution à base d'acide fluorhydrique (FH) ou à base d'acide phosphorique (H3PO4).

Selon un mode de réalisation particulier, l'étape de retrait du film formé de la couche de nitrure de silicium implantée est effectuée par gravure sèche dans un plasma formé dans une enceinte confinée à partir de trifluorure d'azote (NF3) et d'ammoniac (NH3).

De préférence, la gravure sèche comprend : une étape de gravure consistant en la formation de sels solides ; une étape de sublimation des espèces solides. Ce mode de réalisation permet d'obtenir une très bonne sélectivité de la gravure de la couche modifiée par rapport au matériau non modifié de cette même couche et par rapport au matériau semi-conducteur non modifié. En particulier, cette sélectivité de la gravure est très supérieure (typiquement un facteur 10 au moins) à celle obtenue avec une solution de HF.

Selon un mode de réalisation particulier, le procédé comprend une unique étape de modification effectuée de sorte à modifier la couche de nitrure de silicium dans toute son épaisseur en dehors des flancs de la grille et à ne pas modifier la couche de nitrure de silicium dans toute son épaisseur sur les flancs de la grille.

### Réalisation de motifs dans une couche mince anti-réléchissante

Selon un mode de réalisation particulier la couche à graver est recouverte par au moins un bloc de masquage, de préférence à base de résine photosensible. On recouvre le bloc de masquage et la couche à graver par une couche de protection. L'implantation est effectuée de manière à implanter des ions au moins dans des zones de la couche à graver situées en périphérie dudit bloc de masquage, les ions étant choisis de sorte que les zones implantées sont susceptibles d'être gravées sélectivement vis-à-vis du reste de la couche à graver.

L'implantation, en particulier son énergie, la concentration des ions ou la dose utilisée et la durée de l'implantation, sont prévues de sorte que lesdites zones dopées situées en périphérie dudit bloc de masquage et une région non implantée de la couche à graver située sous le bloc de masquage ont une frontière disposée à l'aplomb ou dans le prolongement de la ou des faces latérales dudit bloc de masquage.

De préférence, la couche à graver est une couche anti-réfléchissante.

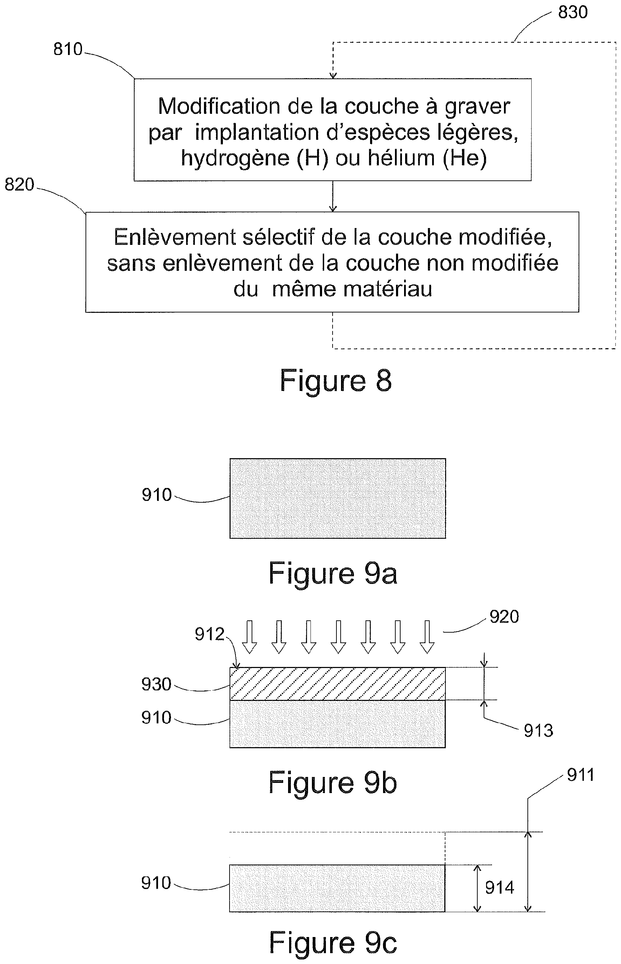

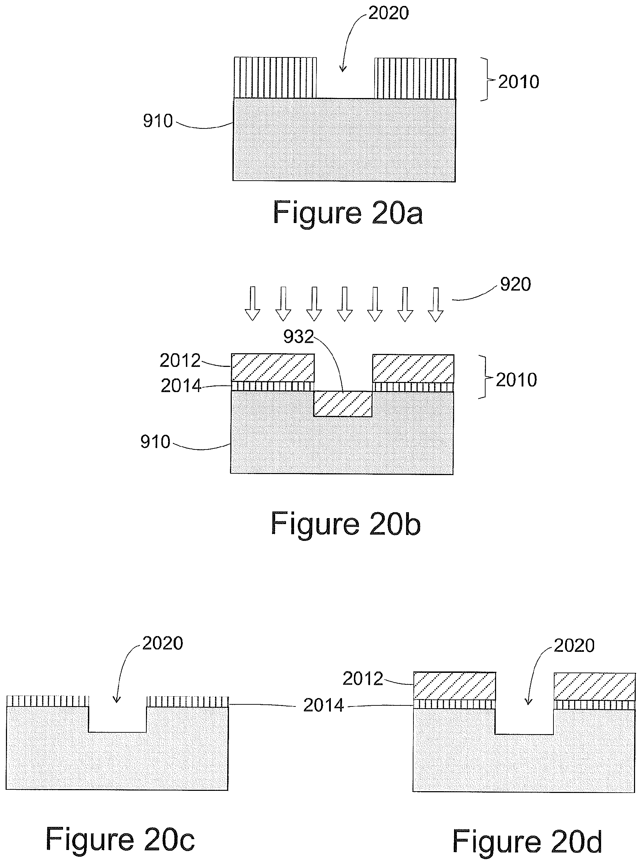

La figure 8 montre les deux étapes principales du procédé de gravure de l'invention. Le procédé de l'invention est basé sur l'exécution d'une première étape 810 de modification du matériau à graver. Comme montré sur la figure 9a, d'une façon générale, le matériau à graver se présente sous la forme d'une couche 910 faisant partie possiblement d'un ensemble de couches de matériaux divers, notamment de matériaux semi-conducteurs servant à la réalisation de circuits intégrés. Le plus souvent le matériau à graver se présente sous la forme de motifs à graver dans une couche continue. Les motifs sont alors délimités par un masque de protection (non représentés) protégeant les zones ne devant pas être gravés entre les motifs. Ce cas est décrit dans les figures 20, 21 et 22.

La modification du matériau consiste à y implanter des espèces légères ou ions légers. Plus précisément, la modification de la couche à graver repose sur l'implantation d'espèces légères comme l'hydrogène (H) ou l'hélium (He).

Comme montré sur la figure 9b, la modification se fait sur une profondeur 913 déterminée par l'opération d'implantation 920 des espèces créant une couche modifiée à partir de la surface 912 exposée à l'opération. Cette couche modifiée forme le film référencé 930.

Comme indiqué précédemment, une modification de la couche effectuée par une implantation à l'aide d'un plasma a pour avantage de permettre une implantation en continue depuis la surface libre de la couche à graver et sur une épaisseur faible, typiquement comprise entre 0 et 100 nm voire entre 0 et 30nm. Elle permet également de bénéficier d'une sélectivité améliorée dès le début de la gravure et d'une vitesse de gravure constante, conduisant à une précision de gravure améliorée. Elle permet également d'effectuer la modification et le retrait de la couche à graver dans une même enceinte.

L'emploi d'un plasma pour implanter la couche à graver permet ainsi de retirer efficacement une couche très fine de nitrure, typiquement comprise entre 1 et 10 nm et plus généralement entre 1 et 30 nm.

La seconde étape 820 consiste à procéder à l'enlèvement ou retrait sélectif du film 930 formé par la couche modifiée en laissant en place la partie non modifiée de la couche 910 sur une épaisseur résiduelle 914.

Optionnellement, des cycles comprenant chacun au moins la première et la seconde étape ci-dessus sont répétés 830 autant de fois que nécessaire pour graver complètement la couche 910, ou atteindre la profondeur de gravure souhaitée, si celle-ci ne peut être obtenue en une seule fois.

Sur les figures 9a à 9c, l'épaisseur initiale de la couche à graver 910 est notée 911, l'épaisseur du film 930 formé par modification de la couche à graver 910 est notée 913 et l'épaisseur restante de la couche à graver 910 après l'étape de retrait est notée 914. Ainsi, au terme du ou des cycles d'implantation et de gravure on a 911 = 913 + 914, avec 913 qui représente l'épaisseur totale des films éliminés et 914 qui représente l'épaisseur de la couche restante après le dernier cycle. Cette équation représente le cas idéal où seul le matériau modifié formant le film 930 est gravé, sans consommation involontaire du matériau non modifiée de la couche 910.

On remarquera ici que l'implantation d'espèces légères comme l'hydrogène ou l'hélium n'induit aucun effet de gravure dans la couche implantée. Ainsi au cours de cette opération, il n'y a donc pas pulvérisation du matériau à graver et déposition de celui-ci sur les surfaces exposées, notamment sur les parois de la chambre de gravure avec les inconvénients mentionnés dans le chapitre sur l'état de la technique.

Les matériaux susceptibles de pouvoir être gravés avec le procédé de l'invention comprennent :
- Tous les matériaux semi-conducteurs incluant le silicium (Si), le germanium (Ge) et tous les semi-conducteurs composites de type III-V et II-VI qui sont obtenus en combinant, respectivement, deux éléments, ou plus, des colonnes II et III d'une part, et V et VI d'autre part, du tableau périodique des éléments. Il s'agit par exemple de l'arséniure de gallium ou AsGa.
- Tous les oxydes et nitrures des matériaux semi-conducteurs ci-dessus.
- Tous les métaux et leurs alliages notamment ceux utilisés couramment par l'industrie de la microélectronique incluant : le titane (Ti) et le nitrure de titane (TiN), le tantale (Ta) et le nitrure de tantale (TaN), le cuivre (Cu), le platine (Pt),
- Tous les matériaux comprenant du silicium (Si) comme l'oxynitrure de silicium (SiON).
- Tous les oxydes métalliques et notamment : l'oxyde d'hafnium (HfO2), l'oxyde de lanthane (LaO), les dioxyde et monoxyde de titane (TiO2 et TiO), l'oxyde de zirconium (ZrO2).
- Le carbone dopé au bore (B:C).

Ainsi, l'invention présente pour avantage de pouvoir être appliquée à un nombre très grand de matériaux à graver.

L'étape 810 de modification de la couche 910 du matériau à graver qui requiert l'implantation d'ion légers hydrogène (H) ou hélium (He) peut être effectuée à partir de deux types d'équipements très différents qui sont décrits brièvement ci-après.

Dans un premier type d'équipement on forme un plasma comprenant ces espèces. La cible à graver est placée dans le plasma et est bombardée par les ions qui y sont produits. Plusieurs options pour la formation du plasma sont possibles :
- On utilise une chambre de gravure plasma standard dans laquelle il est possible de contrôler l'énergie appliquée aux ions légers, i.e., H ou He. On crée alors un plasma à faible densité de type RIE, acronyme de l'anglais « reactive ion etching », c'est-à-dire « gravure ionique réactive ». On peut aussi former un plasma à haute densité dans un graveur de type ICP, acronyme de l'anglais « inductive coupled plasma » c'est-à-dire « plasma à couplage inductif », appareillage dans lequel le champ radiofréquence destiné à former le plasma est produit par une antenne externe à la chambre. On peut encore obtenir la modification de la couche 910 pour former le film 930 à partir d'un plasma à très haute densité obtenu dans un appareillage de type ECR, acronyme de l'anglais « electronic cyclotronic résonance » c'est-à-dire « résonance cyclotron électronique ». Dans ce type d'appareillage le plasma est produit en superposant un champ magnétique statique et un champ électromagnétique à haute fréquence à la fréquence de résonance du cyclotron ou mouvement circulaire d'électrons qui est produit.

- Une autre option consiste à utiliser un plasma dit en immersion de type à « couplage capacitif » ou CCP, acronyme de l'anglais « capacitive coupled plasma » où on applique entre deux électrodes une tension continue ou pulsée élevée. La cible à implanter est placée sur l'une des électrodes, généralement la cathode, et est donc polarisée négativement.

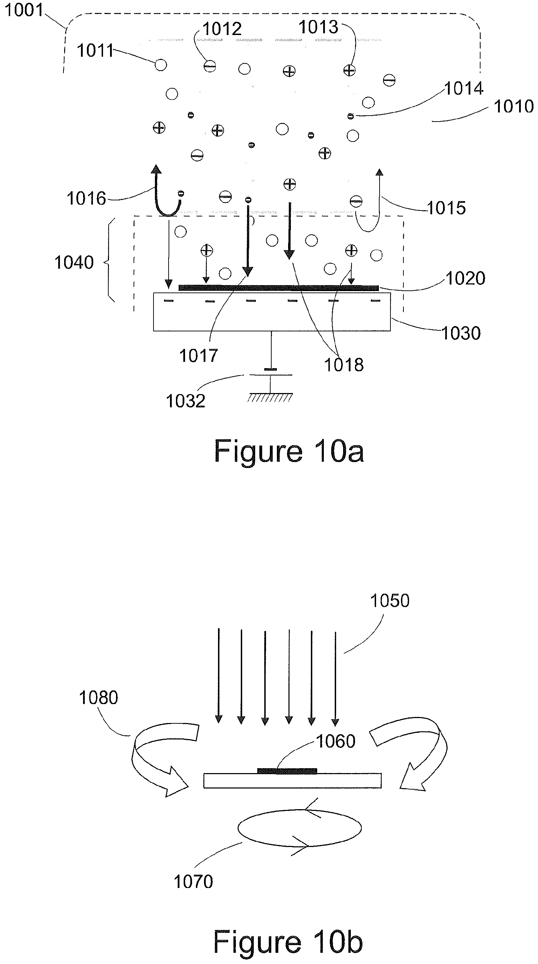

La figure 10a illustre le fonctionnement d'un plasma d'implantation d'espèces légères utilisé pour la première étape 810 du procédé de l'invention où l'on vient procéder à la modification superficielle du matériau à graver 910 pour former le film 930.

Le fonctionnement d'un tel plasma 1010 est bien connu de l'homme du métier. La cible à implanter, généralement une tranche ou substrat 1020 fait à partir d'un matériau semi-conducteur, typiquement du silicium contenant des circuits intégrés en cours de fabrication, est placé sur l'électrode polarisée négativement 1032, c'est-à-dire la cathode 1030. Confiné dans une chambre d'implantation 1001 et du fait de la polarisation, une gaine électrostatique 1040 se forme qui sépare le plasma 1010 du substrat 1020. Le plasma comprend des espèces neutres 1011, des ions chargés négativement 1012, des ions chargés positivement 1013 et des électrons 1014. Les électrons du plasma, plus légers que les ions, peuvent acquérir une vitesse très élevée. Ceux qui acquièrent une énergie suffisante traversent la gaine 1017 et contribuent à la charge négative de la cathode. Les autres sont repoussés 1016 ainsi que les ions négatifs 1015. Un équilibre se crée entre le flux d'ions et le flux d'électrons qui participe à la formation et au maintien de la gaine électrostatique 1040. Celle-ci repousse les charges négatives du plasma mais accélère les ions positifs 1018 vers le substrat où ils sont implantés. Le bombardement étant essentiellement perpendiculaire à la surface de la tranche 1020 la couche à graver est modifiée de façon intrinsèquement anisotrope et donnera donc une gravure anisotrope à l'issue de la seconde étape du procédé de l'invention.

La figure 10b illustre le fonctionnement d'un équipement de type implanteur où on procède à une implantation directe d'espèces légères. L'implantation modifie superficiellement le matériau à graver 910 pour y former le film 930. Le faisceau d'ions 1150 est dirigé par l'équipement sur la cible à graver 1160. On remarquera ici que dans ce type d'équipement on peut avantageusement faire tourner 1170 la cible et/ou l'incliner 1180 de façon à exposer au faisceau d'ions toutes les zones à modifier dans les meilleures conditions.

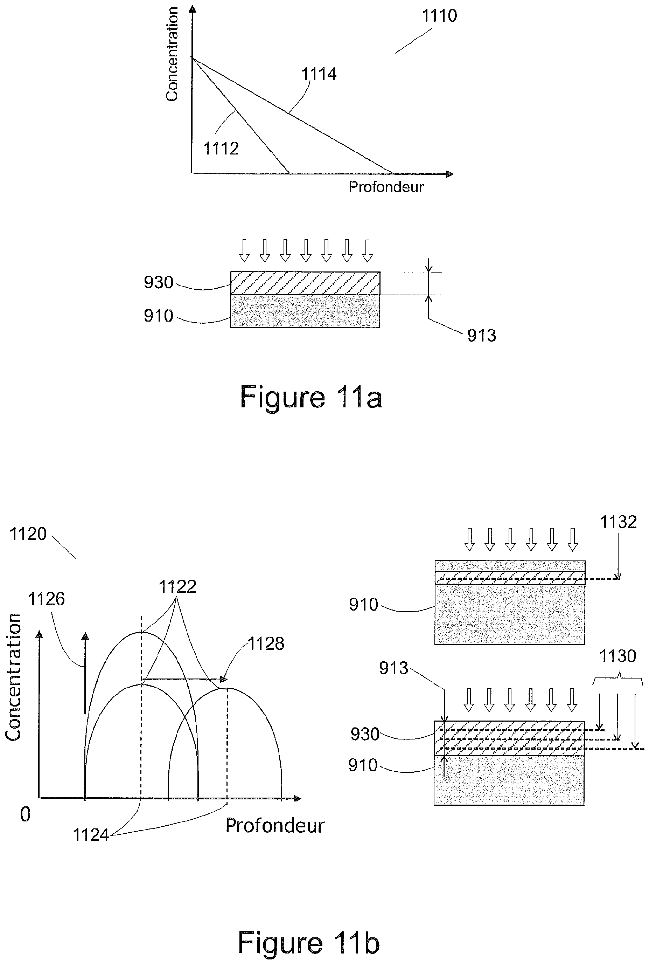

La figure 11a illustre les profils de concentration 1110 des espèces légères implantées dans un plasma depuis la surface. On obtient un gradient de concentration décroissant avec une concentration élevée en surface. En fonction des conditions de réglage du plasma l'énergie acquise par les ions positifs varie, typiquement, dans une gamme allant de 200 électron-volt (eV) jusqu'à 2 à 3 kilo électron-volt (keV). La droite 1112 correspond à une gamme plus faible d'énergies d'implantation que celle de droite 1114 qui permet de modifier la couche à graver sur une profondeur plus importante.

Comme déjà montré sur la figure 9b on obtient donc une couche modifiée formant le film 930 par implantation d'espèces légères H ou He sur une profondeur 913.

La densité des différents types de plasma mentionnés ci-dessus, qui peuvent être utilisés pour mettre en oeuvre l'invention, et les énergies qui peuvent être communiquées aux espèces implantées sont résumées dans le tableau suivant :

| | Type de plasma | | |
|---|---|---|---|
| | CCP | Haute densité | Immersion |
| Densité (atomes/cm³) : | 10⁹ - 10¹⁰ | 10¹¹ - 10¹² | = ou > à 10¹³ |
| Énergie des ions (eV) | 200-500 | 10-200 | jusqu'à 25x10³ |

Les paramètres qui s'appliquent à tout type d'outil de gravure pour lequel on peut contrôler l'énergie imprimée aux ions afin de modifier le film 930 sont résumés ci-après :

| | |
|---|---|
| Épaisseur modifiée : | de 1 nm à quelques dizaines de nm |
| Chimie : | Hydrogène (H2) ou Hélium (He) |
| Puissance de la source : | 0-2000 Watt |
| Puissance de la polarisation (bias) : | 20 Watt à 2000 Watt |
| Pression : | 5 à 300 milli Torr |
| Température : | 10°C à 200°C |
| Temps : | de quelques secondes à quelques centaines de secondes |

Les paramètres qui s'appliquent plus spécifiquement aux plasmas par immersion sont résumés ci-après :

| | |
|---|---|
| Épaisseur modifiée : | de 1 nm à quelques dizaines de nm |
| Chimie : | Hydrogène (H2) ou Hélium (He) |
| Énergie des ions : | 0,1 à quelques dizaines de keV |
| Dose : | À partir de 10¹³atomes/cm² |
| Pression : | 5 à 300 milli Torr |
| Température : | 10°C à 350°C |
| Temps : | de quelques secondes à quelques centaines de secondes |

Les fenêtres des tableaux ci-dessus sont larges et dépendent des applications spécifiques du procédé de l'invention et notamment de l'épaisseur de la couche à graver.

La figure 11b illustre les profils de concentration 1120 des espèces légères implantées à l'aide d'un faisceau d'ions dans un implanteur. On obtient des profils gaussien de concentration qui passent par un maximum 1122 à une profondeur donnée 1124. Avec des faisceaux d'ions de même énergie la concentration augmente 1126 avec l'augmentation de la dose d'ions implantés. Pour une même dose, la profondeur moyenne d'implantation augmente 1128 avec l'augmentation d'énergie communiquée aux ions du faisceau.

Avec un implanteur, pour modifier la couche 930 sur toute l'épaisseur souhaitée 913, il faut donc en général procéder à plusieurs implantations 1130 à des niveaux d'énergie différents et donc à des profondeurs différentes, une seule implantation 1132 ne suffit généralement pas à modifier la couche 930 sur toute son épaisseur depuis la surface.

La source d'ions dans un implanteur standard est typiquement de l'hydrogène (H2) ou de l'hélium (He) sous forme gazeuse, la dose délivrée par le faisceau est supérieure ou égale à 10¹¹ atomes/cm2 et l'énergie des ions peut atteindre quelques kilo eV.

Après avoir modifié la couche à graver à l'étape 810 du procédé de l'invention, dans les conditions décrites dans les figures précédentes, on procède ensuite à l'étape 820 au retrait de cette couche modifiée.

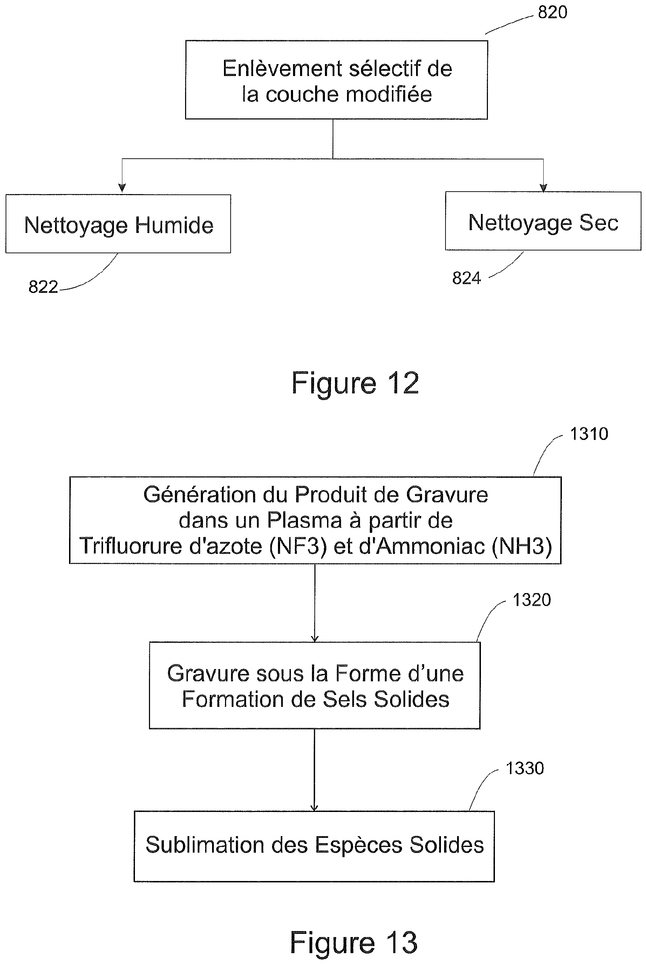

Comme montré sur la figure 12, l'invention décrit de façon non limitative deux options possibles :
- un nettoyage humide 822 ;
- un nettoyage sec 824 ;

Une première option consiste à pratiquer un « nettoyage humide » 822, vocable traduit de l'anglais « wet cleaning », qui se fait à partir de solutions acides, en particulier à base d'acide fluorhydrique (HF) ou d'acide phosphorique (H3PO4) pour le silicium. Bien que le matériau modifié et celui non modifié soient tous deux gravés par ce type de solutions acides le matériau modifié est beaucoup plus sensible à ce type d'attaque. On utilise donc de préférence des solutions hautement diluées, à faible concentration en acide, qui attaquent très faiblement la couche non modifiée, de façon à pouvoir enlever le film 930 sélectivement au matériau qui est non modifiée. On notera ici qu'un nettoyage humide n'est pas limité à l'emploi des solutions acides ci-dessus. Tout type de solution permettant de consommer le matériau modifié est susceptible d'être employé. Par exemple un bain standard de nettoyage dit SC1 (NH4OH/H2O2/H2O) permet de graver un matériau comme le nitrure de titane (TiN). Une forte dilution permet de consommer le TiN qui a été modifié par implantation d'hydrogène sans consommer, ou très faiblement, le nitrure de titane non modifié. Le chlorure d'hydrogène (HCl) ou acide chlorhydrique est également utilisé.

D'une façon pratique l'homme du métier procédera à différents essais de dilution de la solution de nettoyage, par exemple, dans une gamme de valeurs allant d'une très forte dilution à 1% jusqu'à une faible dilution à 75% et en essayant des valeurs intermédiaires comme 10%, 25% et 50%. Une comparaison des vitesses de retrait entre le matériau modifié et celui non modifié est alors effectuée qui permet de choisir le taux de dilution approprié, c'est à dire celui qui permettra de ne pas attaquer le matériau non modifié

L'autre option de nettoyage qualifiée de « nettoyage sec » 824, vocable traduit de l'anglais « dry cleaning », repose sur une méthode décrite par H. Nishini et ses coauteurs dans une publication en anglais intitulée « Damage-free selective etching of Si native oxides using NH3/NF3 and SF6/H2O down flow etching » parue dans le « Journal of Applied Physics » volume 74 (2), en juillet 1993.

Le principe décrit ci-dessus d'un retrait du film 930 par voie sèche dans un plasma fonctionne pour tous les matériaux à base de silicium qui ont été implantés avec des ions H ou He.

Les étapes du procédé de retrait par voie sèche sont décrites dans la figure 13. Une première étape 1310 consiste à générer le produit de gravure dans le plasma selon la réaction chimique suivante :

NF₃+NH₃ → NH₄F + NH₄F.HF

qui fait réagir du trifluorure d'azote (NF₃) avec de l'ammoniac (NH₃).

La gravure se fait au cours d'une deuxième étape 1320, à une température de l'ordre de 30°C et plus généralement entre 10°C et 50°C, sous la forme d'une formation de sels selon la réaction chimique suivante :

NH₄F or NH₄F.HF + SiNH → (NH₄)2SiF₆ (solide) + H₂

au cours d'une opération qui dure entre quelques secondes et quelques minutes et qui s'effectue sous une pression comprise entre quelques milli Torr et quelques Torr. Plus précisément, cette opération dure entre 20 secondes et 2 minutes et s'effectue sous une pression comprise entre 500 milli Torr et 3 Torrs.

Les espèces solides qui sont formées au cours de cette opération sont ensuite sublimées 1330 à une température supérieure à 100°C pendant quelques dizaines de secondes selon la réaction suivante :

(NH₄)2SiF₆ (solid) → SiF₄(g) + NH₃(g) + HF(g)

Les conditions du retrait par voie sèche dans un plasma du film 930 sont résumées dans le tableau ci-dessous :

| | |
|---|---|
| Épaisseur modifiée : | de 1 nm à quelques dizaines de nm |

| Formation des sels (étape 1320) : | |
|---|---|
| Chimie : | à base de fluor et d'hydrogène avec des débits de gaz alimentant le plasma allant de quelques dizaines à quelques centaines de sccm. Les gaz utilisés sont par exemple du trifluorure d'azote (NF₃), de l'hydrogène sous forme gazeuse ou dihydrogène (H2) ou de l'ammoniac (NH₃). Les gaz ci-dessus sont dilués en les mélangeant à d'autres gaz comme l'argon (Ar) ou l'hélium (He) avec des débits allant de 100 à 2000 sccm. |
| | Pour ajuster la gravure, on peut jouer ici sur le rapport fluor (F) sur hydrogène (H) ce qui est équivalent, dans une chimie humide, comme on l'a vu ci-dessus, à jouer sur la dilution d'une solution à base d'acide fluorhydrique (HF) afin qu'elle n'attaque pas le matériau non modifié. |
| Temps : | quelques secondes à quelques minutes. |
| Température : | 10°C à 50°C |
| Pression : | quelques milli Torr à quelques Torr |

| Sublimation (étape 1330) : | |
|---|---|
| Chauffage : | températures supérieures à 100°C pendant quelques dizaines de secondes. |

Ce mode de réalisation permet d'obtenir une très bonne sélectivité de la gravure du matériau modifié de la couche à graver par rapport au matériau non modifié de cette même couche. En particulier, cette sélectivité de la gravure est très supérieure (typiquement un facteur 10 au moins) à celle obtenue avec une solution de HF.

On notera ici que le retrait par voie sèche du film 930 n'est pas limité aux matériaux à base de silicium. En sélectionnant d'autres gaz que le fluor et l'hydrogène on peut générer des sels solides d'autres matériaux qui pourront être sublimés comme décrit ci-dessus.

Après avoir décrit les étapes du procédé de l'invention, c'est-à-dire la modification de la couche à graver 810 et le retrait 820 de celle-ci, des exemples de conditions de mise en oeuvre du procédé sont données ci-après qui ne sont en rien limitatifs de l'invention. Celle-ci peut être mise en oeuvre dans des conditions différentes de celles qui ont été choisies pour illustrer l'invention.

Le tableau suivant donne, pour différents matériaux, les épaisseurs modifiées par implantation d'hydrogène et d'hélium à partir d'un plasma :

| Espèces : | Profondeur d'implantation, en nm, à 1keV, des ions à partir d'un plasma : | |
|---|---|---|
| | H2 | He |
| Oxyde d'hafnium (HfO2) : | 25 | 15 |
| Nitrure de titane (TiN) : | 23 | 14 |
| Silicium (Si) : | 21 | 13 |
| Nitrure de silicium (SiN) : | 31 | 19 |
| Carbone dopé au bore (B:C) : | 17 | 10 |
| Cuivre (Cu) : | 11 | 7 |
| Nitrure de gallium (GaN) : | 24 | 14 |

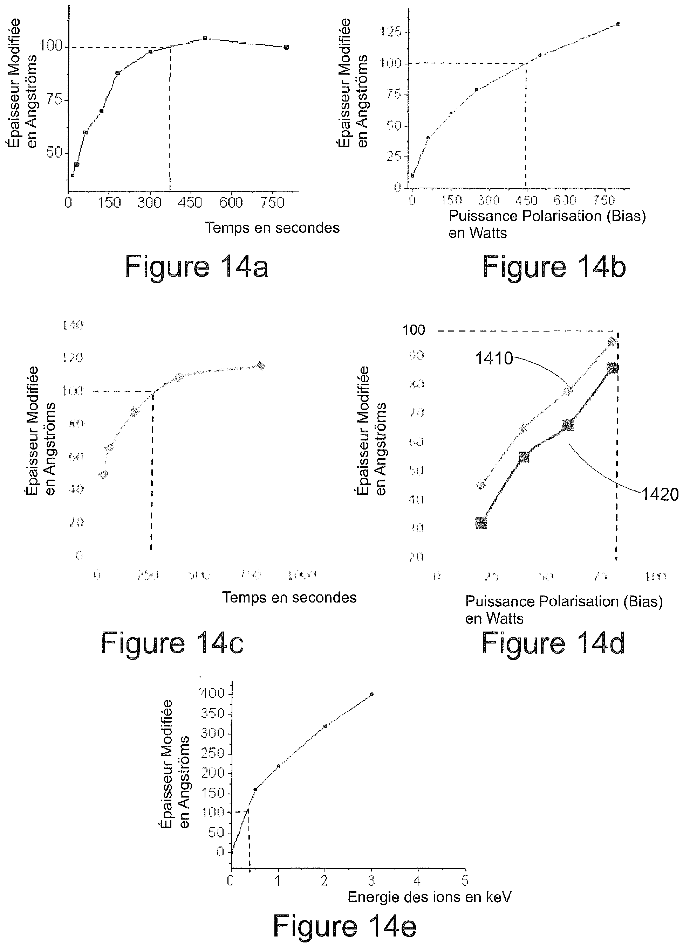

Les figures 14a à 14e donnent pour un matériau particulier, le nitrure de silicium (SiN), les épaisseurs de couches modifiées obtenues en fonction de différentes conditions de mise en oeuvre de l'étape d'implantation d'espèces légères à partir d'un plasma.

Les figures 14a et 14b donnent l'épaisseur modifiée en fonction, respectivement, du temps en secondes et de la puissance de la polarisation (bias) en watts pour un graveur de type ICP et dans les conditions suivantes, pour la figure 14a :
- débit H2 de 200 sccm ; puissance de la source 500 watts ; puissance de la polarisation 150 watts ; pression 10 milli Torr ; température 50°C ;
et pour la figure 14b :
- débit H2 de 200 sccm ; puissance de la source 500 watts ; temps 60 secondes ; pression 10 milli Torr ; température 50°C ;

Les figures 14c et 14d donnent l'épaisseur modifiée en fonction, respectivement, du temps en secondes et de la puissance de la polarisation (bias) en watts pour un graveur de type CCP et dans les conditions suivantes, pour la figure 14c:
- débit H2 de 200 sccm ; puissance de la source nulle (0 watt) ; puissance de la polarisation 40 watts ; pression 10 milli Torr ; température 50°C ;
et pour la figure 14d :
- débit H2 de 200 sccm ; puissance de la source nulle (0 watt) ; temps 60 secondes ; pression 10 milli Torr ; température 50°C . Dans cette figure la courbe 1410 correspond à l'implantation d'hydrogène, la courbe 1420 correspond à l'implantation d'hélium.

La figure 14e correspond au cas d'un plasma par immersion. L'épaisseur implantée est donnée en fonction de l'énergie communiquée aux ions H2 en keV et pour un flux d'ions de 0,1 milli ampères par centimètre carré (mA/cm²).

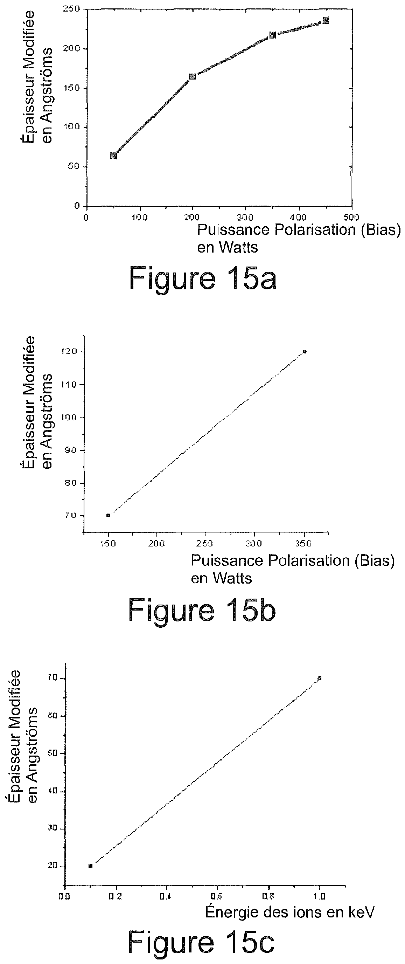

Les figures 15a, 15b et 15c sont similaires aux courbes des figures 14a à 14e pour le matériau de base utilisé en microélectronique c'est-à-dire le silicium (Si). La figure 15a donne l'épaisseur implantée d'ions hélium (He) en fonction de la puissance de la polarisation dans un graveur de type ICP. La puissance de la source est dans ce cas de 150 watts, la pression de 20 milli Torr et la durée de l'opération est de 60 secondes.

La figure 15b correspond à un graveur plasma de type CCP et à l'implantation d'ions hydrogène (H2) pour une puissance de source nulle (0 watt), avec une pression de 20 milli Torr, à une température de 50°C et pendant 60 secondes.

La figure 15c correspond au cas d'un plasma par immersion et à l'implantation d'ions hydrogène (H2). L'épaisseur implantée est donnée en fonction du flux d'ions exprimé en mA/cm². L'énergie communiquée aux ions H2 est dans ce cas de 1 keV.

Des courbes comme celles des figures 14a à 14e et 15a à 15c, qui concernent, respectivement, le nitrure de silicium (SiN) et le silicium (Si), peuvent aussi être établies par l'homme du métier pour tout autre matériau. Comme montré dans les figures ci-dessus, l'épaisseur implantée est principalement déterminée par le temps d'exposition et/ou par l'énergie communiquée aux ions. Le comportement est similaire pour les autres matériaux couramment utilisés en microélectronique.

Pour choisir les paramètres d'implantation l'homme du métier, afin de déterminer le comportement du matériau à graver dans le type d'implanteur choisi, procédera préalablement de préférence à des essais « pleine plaque » afin d'établir des courbes de comportement comparables à celles des figures précédentes. Il en déduira les énergie et dose d'ions, c'est-à-dire le temps d'exposition, à utiliser pour atteindre l'épaisseur voulue de matériau à modifier.

Par exemple, sur la base des résultats montrés dans les figures 14a à 14e les conditions peuvent être les suivantes pour modifier une épaisseur de 10 nm de nitrure de silicium avec des ions H2 dans un graveur de type ICP :
- débit H2 200 sccm, puissance de la source 500 watts, puissance de la polarisation 450 watts, à une pression de 20 milli Torr, une température de 50°C et pendant 60 secondes.
Ou bien :
- débit H2 200 sccm, puissance de la source 500 watts, puissance de la polarisation 150 watts, à une pression de 20 milli Torr, une température de 50°C et pendant 375 secondes.

Dans un graveur de type ICP les conditions pour obtenir les mêmes résultats peuvent être :
- débit H2 200 sccm, puissance de la polarisation 80 watts, à une pression de 20 milli Torr, une température de 50°C et pendant 60 secondes.
Ou bien :
- débit H2 200 sccm, puissance de la polarisation 40 watts, à une pression de 10 milli Torr, une température de 50°C et pendant 250 secondes.

Dans un graveur par immersion les mêmes résultats peuvent être obtenus avec un flux d'ions de 0,1 mA/cm² et une énergie communiquée aux ions de 0,5 keV.

Après avoir donné ci-dessus des exemples de mise en oeuvre d'implantation d'espèces légères pour modifier la couche à graver à partir d'un plasma on trouve ci-après des exemples de mise en oeuvre de retrait du film 930. Ces exemples ne sont en rien limitatifs de l'invention. Celle-ci peut être mise en oeuvre dans des conditions différentes de celles qui ont été choisies pour illustrer l'invention.

Le tableau ci-après correspond à un retrait du film 930 de trois matériaux différents obtenu à l'aide d'un nettoyage humide, c'est-à-dire conformément à l'étape 822 décrite dans la figure 12. Les matériaux avaient été préalablement modifiés, dans une chambre de gravure de type ICP, dans les conditions suivantes : débit de H2 200 sccm ; puissance de la polarisation 150 watts ; puissance de la source 500 watts ; pression 20 milli Torr ; température 50°C ; durée 60 secondes.

| Matériau : | Épaisseur consommée de matériau modifié en nm | | |
|---|---|---|---|
| | après H2 ICP | après 1% HF 30s | après H2 ICP + 1% HF 30s |
| Carbone dopé au bore (B:C) : | 0 | 0 | 14 |
| Oxyde d'hafnium (HfO2) : | 0 | 0 | 8 |
| Oxynitrure de silicium (SiON) : | 0 | 0 | 15 |

Le tableau suivant correspond à un retrait du film 930 de quatre matériaux différents obtenu comme ci-dessus à l'aide d'un nettoyage humide. Les matériaux avaient été préalablement modifiés, dans une chambre de gravure de type CCP, dans les conditions suivantes : débit de H2 200 sccm ; ⁱpuissance de la polarisation 50 watts ; pression 20 milli Torr ; température 50°C ; durée 60 secondes.

| Matériau : | Épaisseur consommée de matériau modifié en nm | | |
|---|---|---|---|
| | après H2 CCP | après 1% HF 30s | après H2 CCP + 1% HF 30s |
| Nitrure de silicium (SiN) : | 0 | 0 | 13 |
| Oxyde de silicium (SiO2) : | 0 | 3 | 11 |
| SiARC (anti réfléchissant) : | 0 | 20 | > 30 |
| Oxyde d'hafnium (HfO2) : | 0 | 0 (HF 49%) | 8 |

Le tableau suivant concerne la gravure de nitrure de titane (TiN) dans un plasma CCP.

| Matériau : | Épaisseur consommée en nm de matériau modifié dans un réacteur de type CCP et utilisation d'un bain de nettoyage dit SC1 (NH4OH/H2O2/H2O, 1:2:2) | | |
|---|---|---|---|
| | après H2 | après 30s SC1 | après H2 + 30s SC1 |
| Nitrure de titane (TiN) : | 0 | 1 | 15 |

Le tableau suivant correspond à un retrait du film 930 de trois matériaux différents obtenu comme ci-dessus à l'aide d'un nettoyage humide. Les matériaux avaient été préalablement modifiés, dans une chambre de gravure de type plasma par immersion, dans les conditions suivantes: flux d'ions 1mA/cm²; énergie des ions 1 keV.

| Matériau : | Épaisseur consommée en nm de matériau modifié dans un plasma par immersion | | |
|---|---|---|---|
| | après H2 CCP seulement | après 1% HF 30s seulement | après H2 + 1% HF 30s |
| Nitrure de silicium (SiN) : | 0 | 0 | 22 |
| Silicium (Si) : | 0 | 0 | 7 |
| Oxyde d'hafnium (HfO2) : | 0 | 0 (HF 49%) | 6 |

Le tableau ci-après concerne la gravure de nitrure de titane (TiN) dans un plasma par immersion

| Matériau : | Épaisseur consommée en nm de matériau modifié dans un plasma par immersion et utilisation d'un bain de nettoyage dit SC1 (NH4OH/H2O2/H2O, 1:2:2) | | |
|---|---|---|---|
| | après H2 | après 30s SC1 | après H2 + SC1 |
| Nitrure de titane (TiN) : | 0 | 2 | 6 |

Les résultats suivants correspondent à un retrait du film 930 obtenu à l'aide d'un nettoyage sec, c'est-à-dire conformément à l'étape 824 décrite dans la figure 12.

Par exemple, pour enlever une couche comprenant 10 nm de nitrure de silicium (SiN), 10 nm d'oxyde de silicium (SiO2) et 30 nm de SiARC, modifiés dans un réacteur de gravure de type ICP, dans les conditions suivantes : débit de H2 200 sccm ; puissance de la source 500 watts ; puissance de la polarisation 450 watts ; durée 60 secondes ; les conditions d'un nettoyage sec peuvent être celles du tableau ci-après.

| | |
|---|---|
| étape 1320 de formation de sels solides : | débits NF3 50 sccm ; NH3 300 sccm ; He 1000 sccm ; température 30°C ; durée 45 secondes. |
| étape 1330 de sublimation : | chauffage à 180°C pendant 60 secondes |

Pour enlever 7 nm de silicium modifié dans un réacteur de gravure de type CCP dans les conditions suivantes : débit de H2 200 sccm ; puissance de la source nulle (0 watt); puissance de la polarisation 150 watts; durée 60 secondes ; les conditions d'un nettoyage sec peuvent être celles du tableau ci-après.

| | |
|---|---|
| étape 1320 de formation de sels solides : | débits NF3 150 sccm ; NH3 250 sccm ; He 1000 sccm ; température 50°C ; durée 120 secondes. |
| étape 1330 de sublimation : | chauffage à 100°C pendant 120 secondes |

L'emploi d'un plasma tel que décrit en figure 10 permet d'utiliser différents gaz. L'invention peut être étendue à tout plasma à base d'hydrogène, par exemple à base d'ammoniac (NH3) et en général à tout composé gazeux à base d'hydrogène ou d'hélium, par exemple, le dyhydrogène (H2) combiné avec de l'azote (N2/H2), avec de l'oxygène O2/H2 ou l'ammoniac combiné avec de l'azote (N2/HN3).

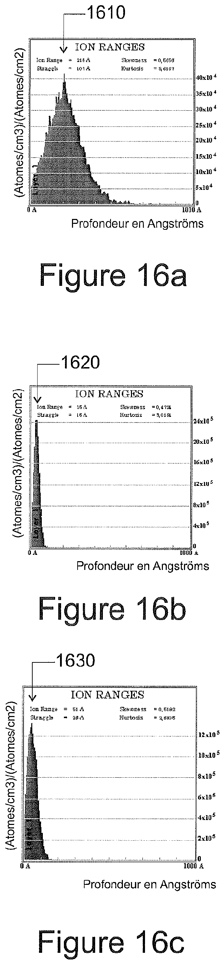

Dans tout ce qui précède l'accent a été mis sur l'implantation des espèces légères hydrogène (H) et hélium (He) qui se sont avérées être le mieux adaptées pour modifier les matériaux à graver. Comme le montre les figures 16a à 16c, on constate que la profondeur d'implantation d'ions argon (Ar) ou azote (N2) est plus faible que celle des espèces légères hydrogène (H) et hélium (He). Les figures ci-dessus comparent les profondeurs de pénétration d'ions, auxquels on a conféré une énergie de 1 keV, dans du silicium. Les figures 16a, 16b et 16c montrent, respectivement, les pénétrations obtenues avec des ions hydrogène, pour comparaison, et avec des ions argon et azote. Les pénétrations moyennes constatées, 1610, 1620 et 1630, sont, respectivement de 20, 3 et 5 nm. On constate également que ces espèces sont moins efficaces pour obtenir la modification de la couche de matériau à graver. De plus, elles sont sujettes à re-déposition notamment sur les parois de la chambre de gravure avec les inconvénients potentiels mentionnés dans le chapitre sur l'état de la technique.

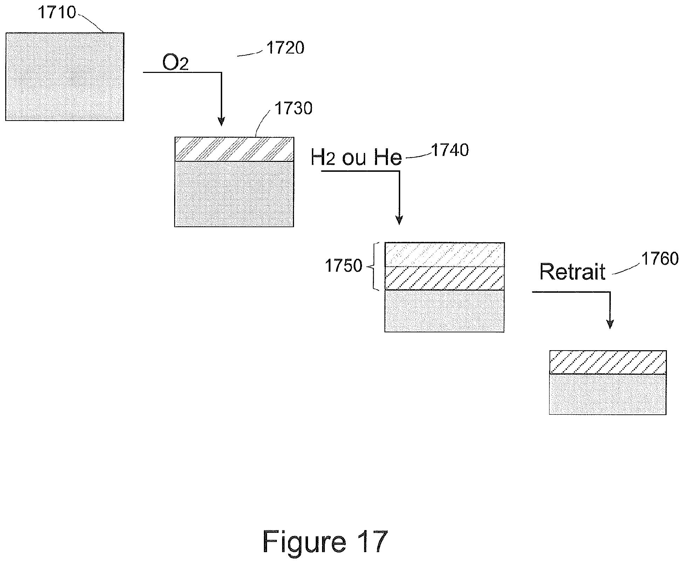

La figure 17 illustre une première façon d'appliquer le procédé de l'invention à la gravure de métaux. Dans le métal à graver 1710 on procède tout d'abord dans ce cas à partir d'un plasma à base d'oxygène (O2) 1720 à une oxydation superficielles 1730 du métal à graver. On effectue ensuite une implantation d'espèces légères H ou He 1740 sur une profondeur 1750 qui s'étend possiblement au-delà de la couche oxydée 1730 du métal 1710. On peut alors effectuer le retrait 1760 de la couche oxydée et implantée. On constate que la couche d'abord oxydée puis modifiée par implantation d'espèces légères s'enlève beaucoup plus facilement à l'aide d'un nettoyage humide que la couche qui a été seulement implantée par les ions légers.

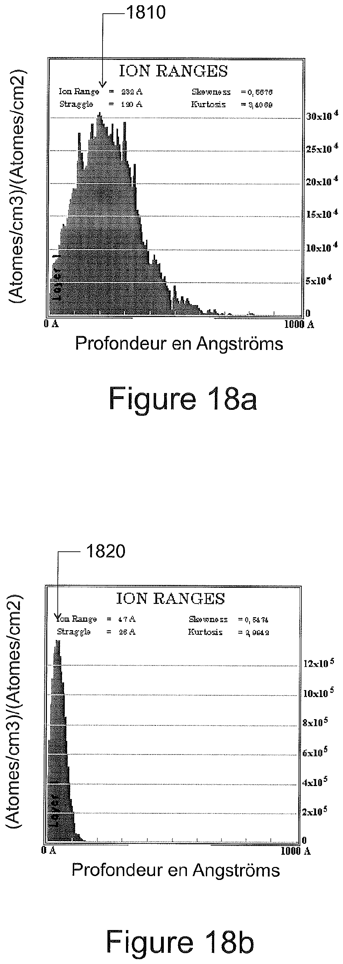

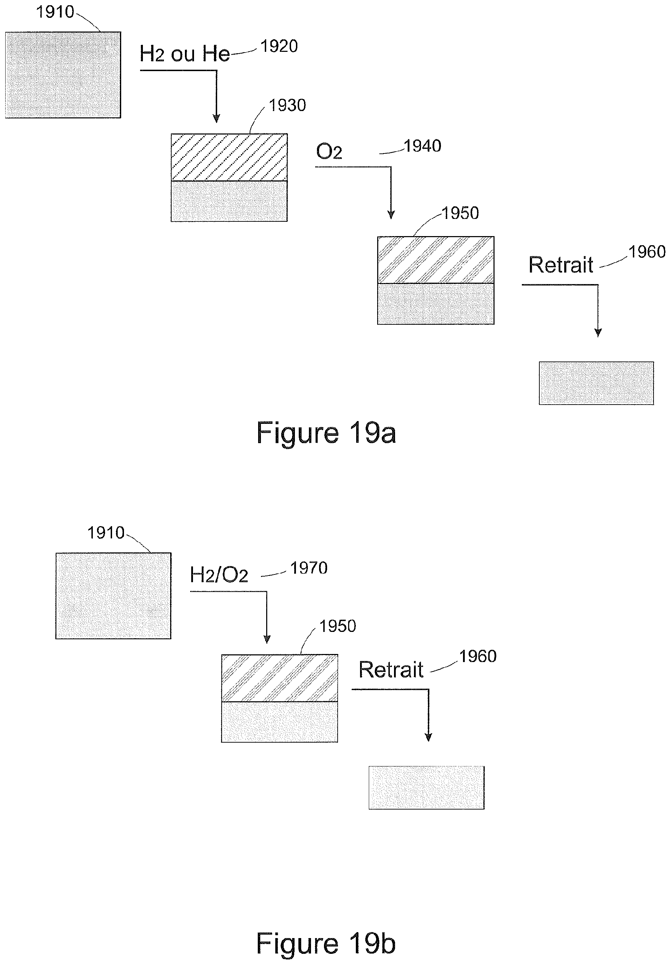

Les figures18a et 18b comparent les profondeurs d'implantation d'ions auxquels on a conféré une énergie de 1 keV, dans du nitrure de titane (TiN). La figure 18a montre les profondeurs obtenues avec des ions hydrogène (H). On constate une pénétration moyenne 1810 de 23 nm. La figure 18b montre les profondeurs obtenues avec des ions oxygène (O) pour lesquels on constate une pénétration moyenne 1820 de 5 nm seulement. Les figures 19a et 19b illustrent, pour les métaux, l'amélioration d'efficacité apportée lors du retrait du film 930 par une oxydation.

La figure 19a montre une autre façon de procéder où l'on pratique d'abord dans le métal à graver 1910 une implantation d'espèces légères H ou He 1920 afin d'obtenir, comme décrit précédemment, une couche modifiée formant un film 1930. On procède ensuite, dans un plasma à base d'oxygène (O2) 1940, à une oxydation 1950 de ce film 1930. On constate là aussi que la couche ainsi modifiée et oxydée peut être est plus facilement enlevée 1960 par une opération de nettoyage humide que si elle est seulement implantée avec des espèces légères H ou He.

En outre, et de manière avantageuse, la modification de la couche par implantation d'ions H ou He avant oxydation permet d'augmenter l'épaisseur de la couche oxydée par comparaison à une oxydation seule.

La figure 19b montre encore une autre façon de faire où l'on procède à une implantation d'ions H2 et à une oxydation simultanée 1970 afin de modifier la couche 1910 pour obtenir le film 1950 au cours d'une seule opération dans un plasma contenant les deux espèces. Un tel plasma avec une chimie à base de O2/ions légers permet de réduire le nombre d'étapes du procédé et de retirer plus facilement le film modifié.

Un exemple de gravure d'une couche métallique avec oxydation est le suivant. Pour enlever dans une couche de nitrure de titane (TiN) une épaisseur de 10 nm:
- On procède tout d'abord à une implantation d'ions H2 à partir d'un plasma formé dans un graveur de type CCP dans les conditions suivantes : débit H2 500 sccm ; puissance de la polarisation 350 watts ; pression 20 milli Torr; température 50°C ; durée 2 minutes.
- Après quoi on introduit de l'oxygène dans les condition suivantes : débit O2 200 sccm ; puissance de la polarisation 350 watts ; pression 20 milli Torr; température 50°C ; durée 2 minutes.

Le retrait du film 930 est ensuite effectué à l'aide d'une opération de nettoyage humide en utilisant une solution de gravure tamponnée dite BOE, acronyme de l'anglais « buffered oxide etch », à base d'acide fluorhydrique diluée à 49% pendant 1 minute.

Les figures 20a à 20d décrivent le procédé de l'invention quand il est appliqué à la gravure anisotrope de motifs définis par un masque.

La figure 20a, montre comme dans la figure 9, la couche de matériau de la couche à graver 910. Toutefois, la gravure ne va pas cette fois se faire sur toute l'étendue de la couche. À l'aide d'un masque, typiquement un masque dur 2010, on va y définir des motifs 2020.

La figure 20b est similaire à la figure 9b et montre le résultat d'une implantation d'ions H ou He 920. Protégée par le masque dur, la couche 910 n'est alors modifiée qu'au droit des motifs 2020 défini dans le masque dur. La portion modifiée est référencée 932. Le masque dur étant exposé au bombardement ionique une partie 2012 de la couche du matériau formant ce dernier est aussi modifiée. Le matériau formant le masque et son épaisseur sont choisis pour qu'il reste une couche résiduelle non modifiée 2014.

Après retrait de la couche modifiée formant le film 932, le motif 2020 est transféré dans le matériau de la couche à graver 910. Deux options sont alors possibles en fonction du type de gravure de la couche modifiée qui a été retenu. La figure 20c illustre le cas où la gravure choisie est seulement sélective vis-à-vis du matériau non modifié de la couche 910. Dans ce cas la partie modifiée du masque dur est aussi gravée et il ne reste en place de ce dernier que la couche résiduelle non modifiée 2014.

Si, au contraire, comme montré sur la figure 20d, on choisit une gravure qui est sélective vis-à-vis du matériau de la couche 910 et de celui du masque dur 2010 alors le masque dur modifié 2012 reste en place.

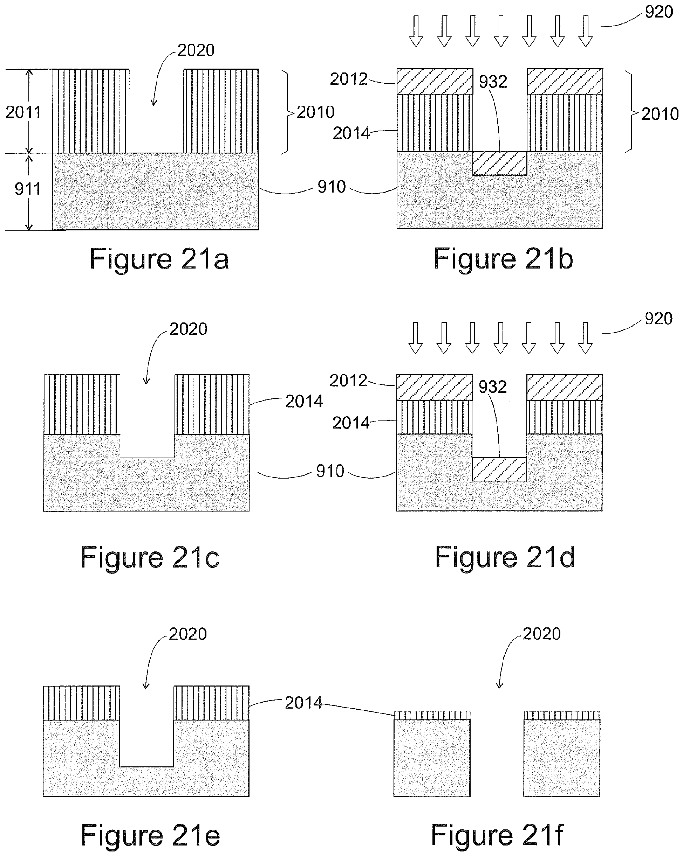

Les figures 21a à 21f décrivent le procédé de l'invention quand il est appliqué à la gravure anisotrope de motifs dans le cas où la gravure n'est pas sélective vis-à-vis du masque dur et qu'il faut procéder à plusieurs cycles de modification de la couche à graver et de retrait de celle-ci pour pouvoir atteindre la profondeur de gravure souhaitée de la couche 910.

Comme montré dans la figure 21a le masque dur doit avoir alors une épaisseur 2011 supérieure à l'épaisseur totale de la couche à graver (où à l'épaisseur qu'il est souhaitable de graver dans cette couche).

Comme précédemment on procède ensuite à une première étape d'implantation 920 d'espèces légères H ou He qui modifie les zones 932 de la couche 910 et la couche 2012 du masque dur. Le résultat est illustré par la figure 21b.

Comme montré sur la figure 21c la gravure de la zone modifiée 932, qui est non sélective vis-à-vis du matériau du masque dur, transfère le motif 2020 dans la couche 910 et enlève aussi la couche 2012 du masque dur. Celui-ci étant épais, une épaisseur suffisante reste en place 2014 qui permet de répéter les opérations ci-dessus de façon à poursuivre la gravure du motif 2020 dans la couche 910.

Le résultat d'une deuxième étape de modification par implantation 920 est illustré sur la figure 21d. Masque dur et couche à graver sont modifiés comme ci-dessus. La figure 21e montre le résultat après enlèvement des couches modifiées. Le masque dur est consommé après chaque gravure. Toutefois, son épaisseur a été choisie pour que l'on puisse répéter le cycle d'opérations ci-dessus autant de fois que nécessaire pour traverser la couche 910 comme montré sur la figure 21f ou atteindre la profondeur de gravure souhaitée. Typiquement, lorsque la gravure de la couche 910 n'est pas sélective par rapport au masque 2010, l'épaisseur initiale 2011 du masque 2010 est alors choisie de manière à être supérieure ou égale à la profondeur totale que l'on souhaite graver dans la couche 910.

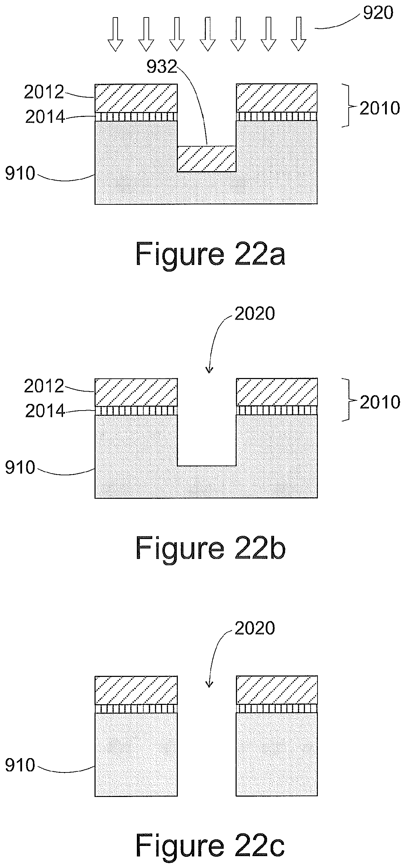

Les figures 22a à 22c complètent les figures 20a, 20b et 20d. Elles illustrent le cas où le masque dur 2010 n'est pas consommé lors de l'opération de retrait des couches modifiées, c'est-à-dire dans le cas où la gravure est sélective vis-à-vis de la partie non modifiée de la couche 910 et est aussi sélective vis-à-vis de la couche modifiée 2012 du masque dur. Les figures 22a à 22c montrent la répétition des cycles de modification et de retrait de la couche modifiée jusqu'à ce que le motif à graver 2020 traverse la couche 910, comme illustré sur la figure 22c où atteint la profondeur de gravure souhaitée comme illustré sur la figure 22b. Les figures 22a à 22c sont analogues aux figures 21d à 21f à la différence qu'il n'y pas dans ce cas consommation du masque dur qui reste en place à chaque cycle et n'a pas besoin d'être d'épaisseur importante comme illustré dans la figure 21a.

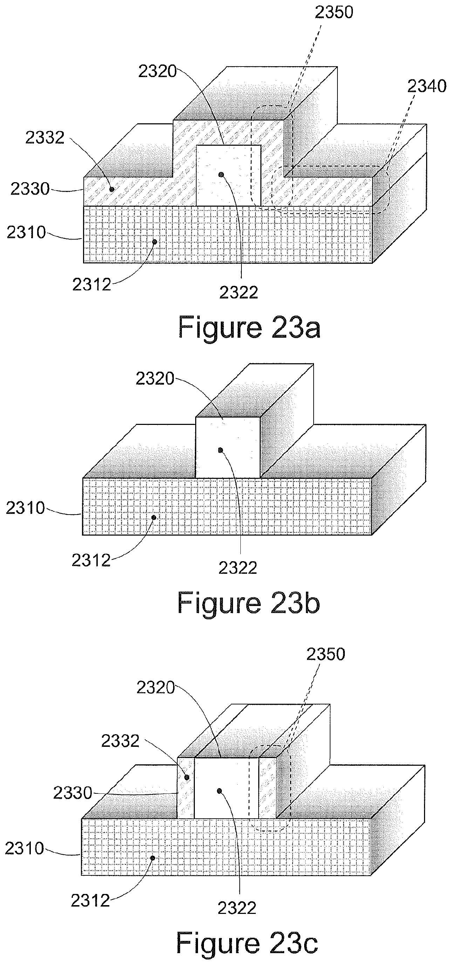

Les figures 23a, 23b et 23c illustrent le concept général de gravure isotrope et anisotrope qu'il faut pouvoir mettre en oeuvre en microélectronique à différents stades de fabrication des dispositifs produits par cette industrie.

La figure 23a montre le cas fréquent de couches et de motifs de matériaux différents présentant un relief et qu'il faut pouvoir graver. Dans l'exemple représentatif illustré par la figure 23a trois matériaux sont en présence sous la forme d'une couche 2310 sensiblement plane d'un premier matériau 2312, d'un deuxième matériau 2322 dans lequel des motifs 2320 ont été définis au cours d'opérations de fabrication précédentes, et d'une couche 2330 d'un troisième matériau 2332 qui recouvre le tout. La couche 2330 présente des différences de niveaux et on peut donc définir dans cette couche des parties horizontales 2340 dans la figure 23a, c'est-à-dire parallèles à la couche 2310 sensiblement plane, et des parties verticales 2350, c'est-à-dire perpendiculaires à la couche 2310 sur les flancs des motifs 2320 en relief.

La figure 23b illustre le cas d'une gravure isotrope de la couche 2330 qui est sélective vis-à-vis des matériaux de la couche 2310 et des motifs 2320. La gravure se fait de manière égale quelle que soit l'orientation des surfaces gravées. En particulier la gravure est identique pour les surfaces verticales 2350 et pour les surfaces horizontales 2340.

La figure 23c montre le résultat d'une gravure anisotrope qui attaque préférentiellement les surfaces perpendiculaires au plan dans lequel la couche 2312 s'étend i.e., les surfaces horizontales. Ce type de gravure laisse la couche gravée 2330, au moins en partie, sur les surfaces verticales 2350, c'est-à-dire sur les flancs du motif 2320.

Ce type de gravure anisotrope est très utile pour réaliser par exemple les espaceurs de grille d'un transistor MOSFET comme décrit dans la figure 6d notamment.

Toutefois, une gravure isotrope est aussi souvent requise pour différentes applications et en particulier pour la réalisation de transistors de type FinFET décrits précédemment. Il faut alors pouvoir enlever le matériau sur les flancs des motifs.

Avec le procédé de l'invention, dans le cas d'une implantation à partir d'un plasma, une façon de réaliser une gravure isotrope, qui demande que l'étape 810 de modification de la couche à graver soit elle-même isotrope, est alors d'utiliser l'option décrite précédemment d'une modification à partir d'un plasma dit par immersion. Ce type de plasma a la particularité de pouvoir être paramétré pour effectuer une implantation anisotrope ou pour effectuer une implantation isotrope.

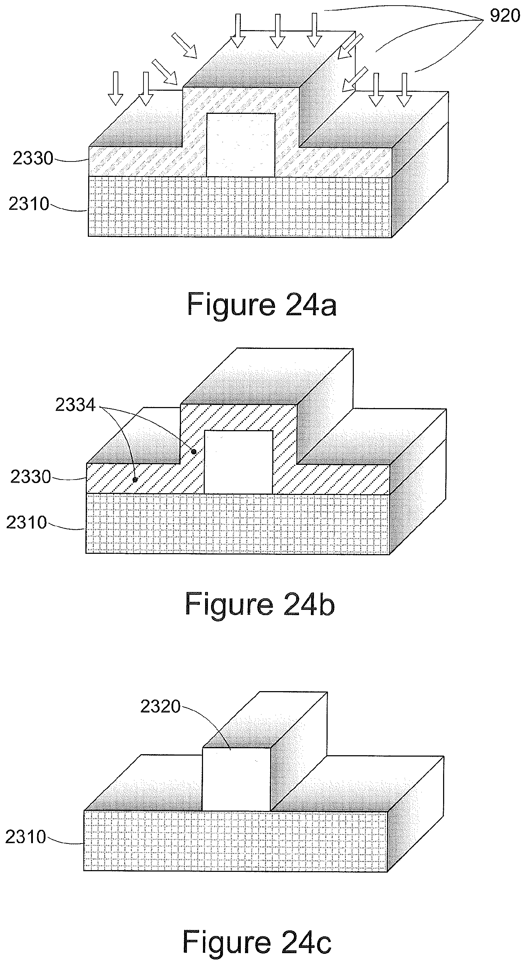

Les figures 24a à 24c illustrent le cas d'une gravure effectuée à partir d'un plasma de type par immersion qui a été paramétré pour que l'implantation se fasse de façon isotrope. Dans ce cas, comme montré sur la figure 24a, la modification n'est pas directionnelle, l'implantation 920 de la couche 2330 se fait également sur les flancs des motifs 2320. Comme montré sur la figure 24b la couche 2330 est à l'issue de cette opération complètement modifiée 2334 aussi bien sur les parties horizontales que verticales de la couche à graver. La figure 24c montre que cette couche modifiée 2334 formant un film est alors enlevée complètement à l'issue de l'étape 820 du procédé de l'invention. Cette figure est identique à la figure 23b. Dans cet exemple, la couche 2330 est donc modifiée sur toute son épaisseur. Ainsi, après retrait, toute la couche 2330 initiale est éliminée.

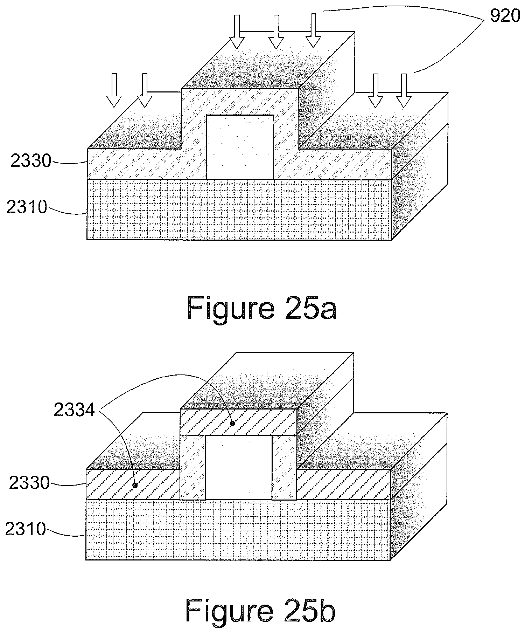

Les figures 25a et 25b illustrent le cas contraire où l'implantation des espèces légères est directionnelle. Comme montré sur la figure 25a le bombardement des ions 920 se fait pour l'essentiel verticalement sur cette figure, c'est-à-dire perpendiculairement au plan des couches du dispositif en cours de fabrication. Seules les surfaces horizontales 2334 sont alors modifiées comme montré sur la figure 25b.

Le résultat final est alors comme illustré précédemment dans la figure 23c. Ainsi, après retrait de la couche modifiée, la couche à graver qui demeure en place est limitée aux surfaces parallèles à la direction d'implantation. Sur cet exemple, la couche à graver est retirée partout en dehors des flancs du motif et demeure en place sur les flancs. Ce mode de réalisation s'avère par exemple très efficace pour réaliser des espaceurs de grille d'un transistor MOSFET comme décrit dans la figure 6d notamment.

On notera que les modes de réalisation illustrés aux figures 20a à 23c et 25a à 25 s'appliquent aussi bien aux implantations d'ions légers réalisées par des implanteurs que par plasma. Toutes les caractéristiques relatives à ces implantations et aux retraits de la couche modifiée que ces implantations génèrent peuvent donc être combinées aux caractéristiques des modes de réalisation des figures 20a à 23c et 25a à 25.

De manière optionnelle, on peut choisir de contrôler précisément l'épaisseur de la couche 2330 non modifiée qui subsiste sur les flancs. Pour cela, suite à la première implantation selon une direction perpendiculaire au plan du substrat 2310, on peut effectuer au moins une deuxième implantation, inclinée par rapport à la direction de la première, de manière à modifier la couche 2330 disposée sur les flancs. Cette deuxième implantation est configurée de manière à ce que seule une portion de l'épaisseur de la couche 2330 soit modifiée. Ainsi, sur les flancs, une partie seulement de l'épaisseur de cette couche 2330 est gravée lors de l'étape de retrait alors qu'en dehors des flancs, toute l'épaisseur de cette couche 2330 est gravée lors de l'étape de retrait. Le résultat obtenu est donc proche de celui de la figure 23c, une épaisseur contrôlée étant prélevée sur les flancs. L'épaisseur de la couche 2330 au niveau des flancs est prise selon une direction perpendiculaire aux flancs recouverts. Par rapport aux figures, l'épaisseur de la couche 2330 au niveau des flancs est prise selon l'horizontal.

Comme déjà mentionné précédemment, pour choisir les paramètres d'implantation et afin de déterminer le comportement du matériau à graver dans le type d'implanteur choisi, l'homme du métier procédera préalablement de préférence à des essais « pleine plaque » afin d'établir des courbes de comportement comparables à celles des figures 14 et 15. Il en déduira les énergie et dose d'ions à utiliser pour atteindre l'épaisseur voulue de matériau à modifier. Il saura également choisir la méthode de retrait de la couche modifiée formant le film qui soit la plus adaptée parmi celles qui ont été décrites : nettoyage humide ou sec et gravure humide c'est-à-dire celle qui assure le mieux un retrait sélectif du film formé par la couche modifiée vis-à-vis des autres couches exposées à la gravure.

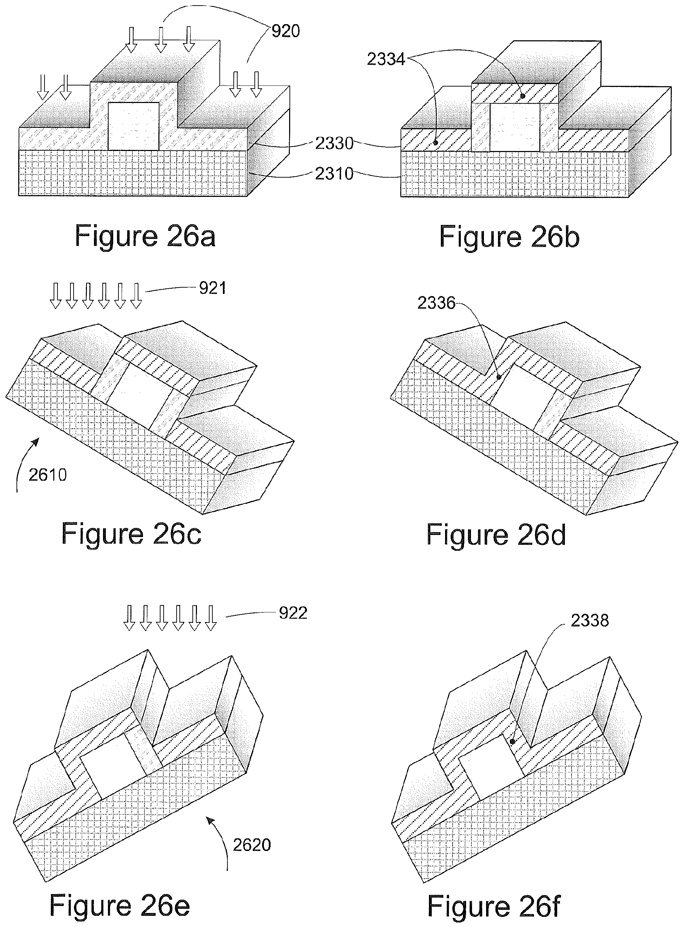

Les figures 26a à 26f décrivent une option de modification de la couche à graver qui s'applique dans le cas d'utilisation d'un implanteur, comme déjà décrit dans les figures 10b et 11b, pour implanter les espèces légères lors de l'étape 810 du procédé de l'invention et obtenir une gravure isotrope en dépit du fait que le faisceau d'ions est très directionnel.

Les figures 26a et 26b sont identiques aux figures 25a et 25b que l'on vient de décrire.

Pour pouvoir, dans un implanteur, modifier les flancs des motifs on procède ensuite, comme montré sur la figure 26c à une deuxième implantation 921 après avoir incliné 2610 la cible dans la chambre d'implantation, c'est-à-dire le substrat en cours de fabrication. Ceci afin de pouvoir exposer un flanc des motifs à graver. Comme déjà mentionné dans la figure 10b, on tire avantage de ce que l'on peut, dans le cas d'un implanteur, orienter la cible au mieux, aussi bien en rotation qu'en inclinaison, pour exposer toutes les zones à graver au faisceau d'ions. Le résultat est comme montré sur la figure 26d. Le matériau à graver est modifié dans les zones exposées 2336 au bombardement directionnel de l'implanteur. Comme montré sur les figures 26e et 26f, on répète l'opération d'implantation 922 après avoir incliné le substrat 2620 afin d'exposer l'autre flanc des motifs et modifier 2338 le matériau dans les régions exposées. Les opérations ci-dessus peuvent avoir à être répétées, avec des orientations différentes, autant de fois que nécessaire pour exposer toutes les surfaces à graver.

Le résultat final est identique à ce qui a été décrit dans la figure 24b où l'on a utilisé un plasma non directionnel. On peut alors procéder comme dans la figure 24c au retrait complet de la couche à graver.

De manière optionnelle, et comme mentionné précédemment, on peut choisir de contrôler précisément l'épaisseur de la couche 2330 non modifiée qui subsiste sur les flancs. Pour cela, les implantations effectuées alors que le substrat est incliné de manière à implanter les flancs est réglée, en dose et énergie notamment, afin que seule une portion de l'épaisseur de la couche 2330 présente sur les flancs soit modifiée. Ainsi, sur les flancs, une partie seulement de l'épaisseur de cette couche 2330 est gravée lors de l'étape de retrait alors qu'en dehors des flancs, toute l'épaisseur de cette couche 2330 est gravée lors de cette étape. Le résultat obtenu est donc proche de celui de la figure 23c, une épaisseur contrôlée étant prélevée sur les flancs.

Il a été décrit précédemment, deux modes de réalisation particuliers permettant de conserver toute ou une portion de la couche à graver sur des flancs d'un motif. Ces modes de réalisation font intervenir une implantation isotrope avec un plasma par immersion ou plusieurs implantations anisotropes selon des directions différentes.

Une application particulièrement avantageuse de ces modes de réalisation concerne la réalisation d'espaceurs en nitrure de silicium sur les flancs d'un motif formant la grille d'un transistor MOSFET par exemple.

Dans cet exemple, la couche à graver est une couche de nitrure de silicium déposée sur une grille à base de silicium et sur une couche, à base de silicium également, sur laquelle la grille est disposée.

L'implantation en particulier son énergie, la concentration et la nature des espèces dopantes ou la dose utilisée et la durée du procédé d'implantation, sont prévues de sorte que la couche de nitrure modifiée puisse être gravée de manière sélective au reste de la couche de nitrure, c'est-à-dire à la couche de nitrure non modifiée, et de la couche sous jacente à la grille lors du retrait.

Selon une option, l'étape de modification de la couche de nitrure de silicium est précédée d'une étape principale de gravure anisotrope comprenant une gravure sèche dans un plasma à base de fluorure de méthyle (CH3F).

Selon une option, l'étape de retrait du film formé de la couche de nitrure de silicium implantée est effectuée par gravure humide sélective audit matériau semiconducteur, obtenue à l'aide d'une solution à base d'acide fluorhydrique (FH) ou à base d'acide phosphorique (H3PO4). Alternativement, l'étape de retrait du film formé de la couche de nitrure de silicium implantée est effectuée par gravure sèche dans un plasma formé dans une enceinte confinée à partir de trifluorure d'azote (NF3) et d'ammoniac (NH3). Par exemple, la gravure sèche comprend : une étape de gravure consistant en la formation de sels solides ; une étape de sublimation des espèces solides.

Selon une option, on effectue une unique étape de modification de sorte à modifier la couche de nitrure de silicium dans toute son épaisseur en dehors des flancs de la grille et à ne pas modifier la couche de nitrure de silicium dans toute son épaisseur sur les flancs de la grille.

Une autre application particulièrement avantageuse de l'invention concerne la réalisation de motifs dans une première couche qui est de préférence une couche anti-réfléchissante. Cette couche anti-réfléchissante est par exemple à base de silicium. Elle est alors communément notée SiARC (ARC pour « Anti Reflective Coating »).

Selon cette option, on forme sur la première couche au moins un bloc de masquage à base de résine photosensible.

On effectue ensuite une implantation, dans des zones de la première couche situées en périphérie dudit bloc de masquage, à l'aide d'au moins une espèce dopante. L'espèce dopante est choisie de sorte que les zones dopées sont susceptibles d'être gravées sélectivement vis-à-vis de la première couche, typiquement en matériau anti-réfléchissant.

On grave ensuite les zones dopées de ladite première mince sélectivement aux zones non dopées.

L'implantation en particulier son énergie, la concentration des espèces dopantes ou la dose utilisée et la durée du procédé d'implantation, sont prévues de sorte que lesdites zones dopées situées en périphérie dudit bloc de masquage et une région non implantée de ladite couche mince située sous le bloc de masquage ont une frontière disposée à l'aplomb ou dans le prolongement de la ou des faces latérales dudit bloc de masquage.

De manière avantageuse mais optionnelle, ce mode de réalisation pourra en outre présenter les caractéristiques facultatives suivantes :
Avantageusement, avant l'implantation, on dépose une couche de protection recouvrant la première couche et ledit bloc de masquage. En outre, la couche de protection, en particulier sa composition et son épaisseur, est prévue de sorte que lesdites zones dopées situées en périphérie dudit bloc de masquage et une région non implantée de ladite première couche située sous le bloc de masquage ont une frontière disposée à l'aplomb ou dans le prolongement de la ou des faces latérales dudit bloc de masquage. Ainsi, cette couche de protection permet d'obtenir une gravure réalisée à l'aplomb de ces flancs.

Ladite première couche peut être une couche anti-réfléchissante SiARC ou à base de Si.

Le procédé peut s'appliquer à une couche à base de silicium telle que, par exemple, une couche de SiO2, ou de SiON, ou de SiOC.

Ladite couche protection peut avoir une épaisseur faible et peut être comprise entre 1 nanomètre et 3 nanomètres.

Une épaisseur trop importante de la couche de protection empêche de placer la frontière entre zones dopée et zones non-dopées à l'aplomb ou dans le prolongement de la ou des faces latérales dudit bloc de masquage.

Ladite espèce dopante peut être à base d'hydrogène, ce qui permet de former des zones dopées comportant des liaisons Si-H dans le cas où la première couche contient du Si.

La gravure sélective peut être ainsi réalisée, par exemple, à l'aide d'un bain humide à base d'acide fluorhydrique (HF) dilué dans l'eau de-ionisée.

Le dopage peut être réalisé avec une énergie d'implantation faible en particulier comprise entre 100eV et 600eV.

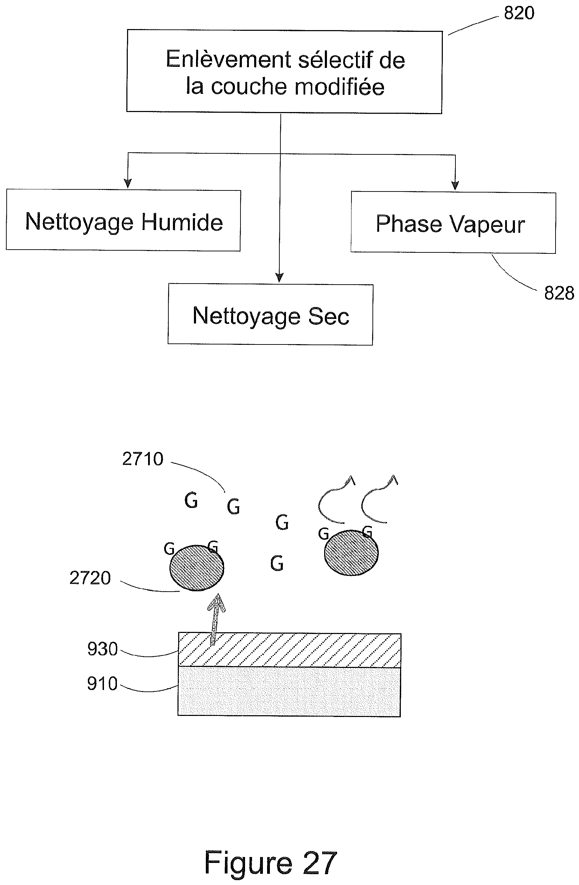

La figure 27 illustre une option supplémentaire de retrait 820 du film 930. Celle-ci se fait en phase vapeur 828 en présence d'un gaz 2710 qui réagit directement 2720 avec le film formé par la couche modifiée. Tous les gaz qui permettent de former des produits de réaction volatils avec le matériau à graver pourront être utilisés. Par exemple, pour graver une couche de silicium, on pourra recourir à une implantation d'hydrogène (H) et la gaz utilisé pour le retrait peut être du HF.

Ainsi le procédé de gravure de l'invention présente de nombreux avantages :
- une grande sélectivité de gravure vis-à-vis des matériaux qui n'ont pas été modifiés par implantation d'espèces légères ;
- la possibilité de pouvoir graver un très grand nombre de matériaux ;
- l'absence de pulvérisation des matériaux exposés pendant les étapes d'implantation et de retrait de la couche modifiée formant le film;
- la possibilité de pouvoir pratiquer une gravure directionnelle anisotrope, permettant de ce fait d'obtenir un rapport de forme élevé ;
- l'absence de formation d'une couche de passivation sans l'inconvénient majeur associé c'est-à-dire le défaut de contrôle des dimensions critiques ;
- l'utilisation d'une chimie non polluante facilement contrôlable ;
- le fait de ne pas avoir besoin de recourir à des températures élevées de gravure qui sont potentiellement dommageables pour les dispositifs en cours de fabrication ;
- la mise en oeuvre d'un processus de gravure simple basé essentiellement sur la modification du matériau à graver ne nécessitant qu'un contrôle des doses d'ions à employer et l'énergie à leur communiquer ;
- le non recours à un nettoyage systématique des parois de la chambre de gravure qui était nécessaire pour éviter les dérives constatées des procédés de gravure antérieurs et le manque de reproductibilité entre chambres plasma.

L'invention n'est pas limitée aux seuls modes et exemples de réalisation décrits ci-dessus, mais s'étend à tous les modes de réalisation entrant dans la portée des revendications.

## Revendications

1. Procédé microélectronique de gravure d'une couche à graver (910, 1910, 2330), **caractérisé en ce qu'**il comprend les étapes successives suivantes:
- modification (810) de la couche à graver (910, 1910, 2330) sur une profondeur (913) s'étendant depuis la surface de la couche à graver et jusqu'à une portion au moins de l'épaisseur de la couche à graver de manière à former un film (930, 1930, 1950, 932, 2334), la modification comprenant l'implantation (920) d'ions légers dans la couche à graver (910, 1910, 2330); l'implantation étant réalisée à partir d'un plasma comprenant les ions légers, les ions légers étant pris parmi l'hélium et l'hydrogène;
- retrait (820) du film (930, 1930, 1950, 932, 2334) comprenant une gravure sélective du film (930, 1930, 1950, 932, 2334) par rapport à au moins une couche (910, 1910, 2330, 2310, 2320) sous-jacente au film (930, 1930, 1950, 932, 2334).

2. Procédé selon la revendication précédente, dans lequel l'implantation est effectuée de manière à ce que les ions légers implantés soient répartis de manière ininterrompue depuis la surface de la couche à graver (910, 1910, 2330) et jusqu'à ladite profondeur et dans lequel ladite profondeur est comprise entre 1 nm et 30nm et de préférence entre 1nm et 10 nm.

3. Procédé selon l'une quelconque des revendications précédentes, dans lequel l'étape de retrait du film (930, 1930, 1950, 932, 2334) comprend au moins l'une des étapes suivantes : une étape de nettoyage par voie humide, une étape de nettoyage par voie sèche, une étape de gravure plasma.

4. Procédé selon l'une quelconque des revendications précédentes, dans lequel l'étape de retrait du film (930, 1930, 1950, 932, 2334) comprend au moins une étape de gravure en phase vapeur avec un gaz réagissant avec le film pour former un produit de réaction volatil.

5. Procédé selon l'une quelconque des revendications précédentes, dans lequel la couche à graver est faite d'un matériau à base d'un matériau semi-conducteur comprenant : le silicium (Si), le germanium (Ge), le silicium germanium (SiGe).

6. Procédé selon l'une quelconque des revendications 1 à 4, dans lequel la couche à graver est faite d'un matériau à semi-conducteur composite de type III-V et II-VI obtenu en combinant, respectivement, deux éléments, ou plus, des colonnes II et III d'une part, et V et VI d'autre part, du tableau périodique des éléments.

7. Procédé selon l'une quelconque des deux revendications précédentes, dans lequel la couche à graver est un oxyde ou un nitrure dudit matériau semi-conducteur.

8. Procédé selon l'une quelconque des revendications 1 à 4, dans lequel la couche à graver est un oxyde métallique ou du carbone dopé au bore (B:C).

9. Procédé selon l'une quelconque des revendications 1 à 4, dans lequel le matériau de la couche à graver est du métal ou un alliage de métaux.

10. Procédé selon l'une quelconque des revendications précédentes, dans lequel la modification comprend, avant l'implantation des ions légers, une oxydation (1940) d'une partie de la couche à graver (1910) depuis sa surface.

11. Procédé selon l'une quelconque des revendications 1 à 9, dans lequel la modification comprend, après l'implantation (1940) des ions légers et avant le retrait du film, une oxydation d'une partie de la couche à graver (1910) depuis sa surface.

12. Procédé selon l'une quelconque des revendications 1 à 9, dans lequel la modification comprend une oxydation (1970) d'une partie de la couche à graver (1910) depuis sa surface simultanément à l'implantation des ions légers et dans lequel l'implantation d'ions légers et d'oxygène est de préférence réalisée à partir d'un plasma comprenant les ions légers et de l'oxygène.

13. Procédé selon l'une quelconque des revendications précédentes, dans lequel la couche à graver (2330) recouvre des motifs (2320) présentant des flancs et l'implantation (920) des ions légers est réalisée de manière anisotrope selon une direction qui est sensiblement parallèle audits flancs et dans lequel au moins un motif est une grille d'un transistor située au-dessus d'une couche en un matériau semi-conducteur, dans lequel la couche à graver est une couche de nitrure de silicium recouvrant le motif et la couche en un matériau semi-conducteur, dans lequel l'étape de modification est effectuée de manière à implanter des ions légers sur toute l'épaisseur de la couche de nitrure de silicium située en périphérie de la grille et éventuellement sur une portion de l'épaisseur de la couche de nitrure de silicium située sur des flancs de la grille et dans lequel les étapes d'implantation et de retrait du film sont effectuées de manière à graver le film sélectivement au matériau semi-conducteur et au nitrure de silicium non modifiée.

14. Procédé selon l'une quelconque des revendications 1 à 12, dans lequel la couche à graver est recouverte par au moins un bloc de masquage et dans lequel on recouvre le bloc de masquage et la couche à graver par une couche de protection, dans lequel l'implantation est effectuée de manière à implanter des ions légers au moins dans des zones de la couche à graver situées en périphérie dudit bloc de masquage, les ions légers étant choisis de sorte que les zones implantées sont susceptibles d'être gravées sélectivement vis-à-vis du reste de la couche à graver.

15. Procédé selon l'une quelconque des revendications précédentes dans lequel les étapes de modification et de retrait de la couche à graver sont réalisées dans un même réacteur plasma.

## Patentansprüche

1. Mikroelektronisches Verfahren zum Ätzen einer zu ätzenden Schicht (910, 1910, 2330), **dadurch gekennzeichnet, dass** es die nachstehenden, aufeinanderfolgenden Schritte umfasst:
- Modifizieren (810) der zu ätzenden Schicht (910, 1910, 2330) über eine Tiefe (913), die sich von der Oberfläche der zu ätzenden Schicht zumindest bis zu einem Abschnitt der Dicke der zu ätzenden Schicht erstreckt, so dass eine Folie (930, 1930, 1950, 932, 2334) gebildet wird, wobei die Modifizierung die Implantation (920) von leichten Ionen in die zu ätzende Schicht (910, 1910, 2330) umfasst; wobei die Implantation ausgehend von einem Plasma mit den leichten Ionen erfolgt, wobei die leichten Ionen aus Helium und Wasserstoff genommen werden;
- Entfernen (820) der Folie (930, 1930, 1950, 932, 2334) mit der selektiven Ätzung der Folie (930, 1930, 1950, 932, 2334) von zumindest einer der Folie (930, 1930, 1950, 932, 2334) zugrundeliegenden Schicht (910, 1910, 2330, 2310, 2320).

2. Verfahren nach dem vorangehenden Anspruch, wobei die Implantation so erfolgt, dass die implantieren, leichten Ionen ununterbrochen von der Oberfläche der zu ätzenden Schicht (910, 1910, 2330) bis hin zur genannten Tiefe verteilt sind und wobei die genannte Tiefe zwischen 1 nm und 30 nm und vorzugsweise zwischen 1 nm und 10 nm beträgt.

3. Verfahren nach einem der vorangehenden Ansprüche, wobei der Schritt des Entfernens der Folie (930, 1930, 1950, 932, 2334) zumindest einen der nachfolgenden Schritte umfasst: einen Schritt der Nassreinigung, einen Schritt der Trockenreinigung, einen Schritt des Plasmaätzens.

4. Verfahren nach einem der vorangehenden Ansprüche, wobei der Schritt des Entfernens der Folie (930, 1930, 1950, 932, 2334) zumindest einen Schritt der Dampfphasenätzung mit einem Gas umfasst, das mit der Folie reagiert, um ein flüchtiges Reaktionsprodukt zu bilden.

5. Verfahren nach einem der vorangehenden Ansprüche, wobei die zu ätzende Schicht aus einem Material auf Basis eines Halbleitermaterials, umfassend Silicium (Si), Germanium (Ge), Silicium-Germanium (SiGe), hergestellt ist.

6. Verfahren nach einem der Ansprüche 1 bis 4, wobei die zu ätzende Schicht aus einem Halbleiterverbundmaterial vom Typ III-V und II*-*VI hergestellt ist, das durch Kombination von zwei oder mehr Elementen der Spalten II und III einerseits und V und VI anderseits aus dem Periodensystem der Elemente erhalten wird.

7. Verfahren nach einem der beiden vorangehenden Ansprüche, wobei die zu ätzende Schicht ein Oxid oder ein Nitrid des Halbleitermaterials ist.

8. Verfahren nach einem der Ansprüche 1 bis 4, wobei die zu ätzende Schicht ein Metalloxid oder Bor-dotierter Kohlenstoff (B:C) ist.

9. Verfahren nach einem der Ansprüche 1 bis 4, wobei das Material der zu ätzenden Schicht ein Metall oder eine Metalllegierung ist.

10. Verfahren nach einem der vorangehenden Ansprüche, wobei die Modifizierung vor der Implantation der leichten Ionen eine Oxidierung (1940) eines Teils der zu ätzenden Schicht (1910) ausgehend von ihrer Oberfläche umfasst.

11. Verfahren nach einem der Ansprüche 1 bis 9, wobei die Modifizierung vor der Implantation (1940) der leichten Ionen und vor dem Entfernen der Folie eine Oxidierung eines Teils der zu ätzenden Schicht (1910) ausgehend von ihrer Oberfläche umfasst.

12. Verfahren nach einem der Ansprüche 1 bis 9, wobei die Modifizierung eine Oxidierung (1970) eines Teils der zu ätzenden Schicht (1910) ausgehend von ihrer Oberfläche gleichzeitig mit der Implantation der leichten Ionen umfasst und wobei die Implantation von leichten Ionen und Sauerstoff vorzugsweise ausgehend von einem Plasma erfolgt, das die leichten Ionen und Sauerstoff enthält.

13. Verfahren nach einem der vorangehenden Ansprüche, wobei die zu ätzende Schicht (2330) Muster (2320) überdeckt, die Flanken aufweisen, und die Implantation (920) der leichten Ionen anisotrop in einer Richtung erfolgt, die im Wesentlichen parallel zu den Flanken verläuft, und wobei zumindest ein Muster ein Gate eines Transistors ist, das über einer Schicht aus einem Halbleitermaterial liegt, wobei die zu ätzende Schicht eine Schicht aus Siliziumnitrid ist, die das Muster und die Schicht aus einem Halbleitermaterial überdeckt, wobei der Schritt der Modifizierung so erfolgt, dass leichte Ionen über die gesamte Dicke der Siliziumnitridschicht implantiert werden, die am Umfang des Gates und gegebenenfalls an einem Abschnitt der Dicke derjenigen Siliziumnitridschicht liegt, die an den Flanken des Gates liegt, und wobei die Schritte der Implantation und der Entfernung der Folie so erfolgen, dass die Folie selektiv mit dem Halbleitermaterial und dem Siliziumnitrid geätzt wird, das nicht modifiziert ist.

14. Verfahren nach einem der Ansprüche 1 bis 12, wobei die zu ätzende Schicht mit zumindest einem Maskierblock überdeckt ist und wobei der Maskierblock und die zu ätzende Schicht mit einer Schutzschicht überdeckt werden, wobei die Implantation so erfolgt, dass leichte Ionen zumindest in den Bereichen der zu ätzenden Schicht implantiert werden, die am Umfang des Maskierblocks liegen, wobei die leichten Ionen so gewählt sind, dass die implantierten Bereiche selektiv gegenüber der restlichen zu ätzenden Schicht geätzt werden können.

15. Verfahren nach einem der vorangehenden Ansprüche, wobei die Schritte der Modifizierung und Entfernung der zu ätzenden Schicht in einem gleichen Plasmareaktor erfolgen.

## Claims

1. Microelectronic method for engraving a layer to be engraved (910, 1910, 2330), **characterised in that** it comprises the following successive steps:
- modifying (810) the layer to be engraved (910, 1910, 2330) over a depth (913) extending from the surface of the layer to be engraved and to a portion at least of the thickness of the layer to be engraved so as to form a film (930, 1930, 1950, 932, 2334), the modification comprising the implantation (920) of light ions in the layer to be engraved (910, 1910, 2330); the implantation being done from a plasma comprising light ions, the light ions being taken from among helium and hydrogen;
- removing (820) the film (930, 1930, 1950, 932, 2334) comprising a selective engraving of the film (930, 1930, 1950, 932, 2334) with respect to at least one layer (910, 1910, 2330, 2310, 2320) underlaying the film (930, 1930, 1950, 932, 2334).

2. Method according to the preceding claim, wherein the implantation is done such that the light ions implanted are distributed continuously from the surface of the layer to be engraved (910, 1910, 2330) and to said depth and wherein said depth is between 1nm and 30nm and preferably between 1nm and 10nm.

3. Method according to any one of the preceding claims, wherein the step of removing the film (930, 1930, 1950, 932, 2334) comprises at least one of the following steps: a step of wet-cleaning, a step of dry-cleaning, a step of plasma engraving.

4. Method according to any one of the preceding claims, wherein the step of removing the film (930, 1930, 1950, 932, 2334) comprises at least one step of engraving in vapour phase with a gas reacting with the film to form a volatile reaction product.

5. Method according to any one of the preceding claims, wherein the layer to be engraved is made of a material based on a semi-conductive material: silicon (Si), germanium (Ge), silicon germanium (SiGe).

6. Method according to any one of claims 1 to 4, wherein the layer to be engraved is made from a semi-conductive composite material, of type III-V and II-VI obtained by combining, respectively, two elements, or more, of columns II and III on the one hand, and V and VI on the other hand, of the periodic table of elements.

7. Method according to any one of the two preceding claims, wherein the layer to be engraved is an oxide or a nitride of said semi-conductive material.

8. Method according to any one of claims 1 to 4, wherein the layer to be engraved is a metal oxide or made of boron-doped carbon (B:C).

9. Method according to any one of claims 1 to 4, wherein the material of the layer to be engraved is metal or a metal alloy.

10. Method according to any one of the preceding claims, wherein the modification comprises, before implantation of the light ions, an oxidation (1940) of a part of the layer to be engraved (1910) from the surface thereof.

11. Method according to any one of claims 1 to 9, wherein the modification comprises, after implantation (1940) of the light ions and before the removal of the film, an oxidation of a part of the layer to be engraved (1910) from the surface thereof.

12. Method according to any one of claims 1 to 9, wherein the modification comprises an oxidation (1970) of a part of the layer to be engraved (1910) from the surface thereof, simultaneously to the implantation of the light ions and wherein the implantation of light ions and oxygen is preferably done from a plasma comprising light ions and oxygen.

13. Method according to any one of the preceding claims, wherein the layer to be engraved (2330) covers the patterns (2320) having flanks and the implantation (920) of the light ions is done anisotropically along a direction which is substantially parallel to said flanks and wherein at least one pattern is a grid of a transistor situated above a layer made of a semi-conductive material, wherein the layer to be engraved is a silicon nitride layer covering the pattern and the layer made of a semi-conductive material, wherein the modification step is carried out so as to implant the light ions over the whole thickness of the silicon nitride layer situated at the periphery of the grid and possibly over a portion of the thickness of the silicon nitride layer situated on the flanks of the grid and wherein the steps of implanting and removing the film are carried out so as to engrave the film selectively with semi-conductive material and with non-modified silicon nitride.

14. Method according to one of claims 1 to 12, wherein the layer to be engraved is covered by at least one masking block and wherein the masking block and the layer to be engraved is covered by a protective layer, wherein the implantation is done so as to implant the light ions at least in the zones of the layer to be engraved situated at the periphery of said masking block, the light ions being selected such that the implanted zones are likely to be engraved selectively vis-à-vis the remainder of the layer to be engraved.

15. Method according to any one of the preceding claims, wherein the steps of modifying and removing the layer to be engraved are carried out in one same plasma reactor.
